# EUROPEAN PATENT SPECIFICATION

(11) **EP 2 988 403 B1**
(45) Date of publication and mention of the grant of the patent: **02.10.2019**
(21) Application number: 14275170.0
(22) Date of filing: 19.08.2014
(51) Int. Cl.: H02M 1/088, H03K 17/10

(54) **A semiconductor switching string**
Halbleiterschaltstrang
Chaîne de commutation à semi-conducteur

(43) Date of publication of application: 24.02.2016
(73) Proprietor: General Electric Technology GmbH, 5400 Baden (CH)
(72) Inventor: VERSHININ, Konstantin, Stafford ST17 0PS (GB)
(74) Representative: Rüger Abel Patentanwälte PartGmbB

(56) References cited:
- EP-A1- 2 445 110
- GERSTER C: "Fast high-power/high-voltage switch using series-connected IGBTs with active gate-controlled voltage-balancing", APPLIED POWER ELECTRONICS CONFERENCE AND EXPOSITION, 1994. APEC '94. C ONFERENCE PROCEEDINGS 1994., NINTH ANNUAL ORLANDO, FL, USA 13-17 FEB. 1994, NEW YORK, NY, USA,IEEE, 13 February 1994 (1994-02-13), pages 469-472, XP010118534, DOI: 10.1109/APEC.1994.316362 ISBN: 978-0-7803-1456-6
- GALLUZZO A ET AL: "Snubberless balancement of series connected insulated gate devices by a novel gate control strategy", INDUSTRY APPLICATIONS CONFERENCE, 1997. THIRTY-SECOND IAS ANNUAL MEETI NG, IAS '97., CONFERENCE RECORD OF THE 1997 IEEE NEW ORLEANS, LA, USA 5-9 OCT. 1997, NEW YORK, NY, USA,IEEE, US, vol. 2, 5 October 1997 (1997-10-05), pages 968-974, XP010248449, DOI: 10.1109/IAS.1997.628978 ISBN: 978-0-7803-4067-1
- BELVERDE G ET AL: "Active voltage sharing of series connected strings of IGBT devices in bridge applications", INDUSTRY APPLICATIONS CONFERENCE, 1998. THIRTY-THIRD IAS ANNUAL MEETIN G. THE 1998 IEEE ST. LOUIS, MO, USA 12-15 OCT. 1998, NEW YORK, NY, USA,IEEE, US, vol. 2, 12 October 1998 (1998-10-12), pages 817-824, XP010313010, DOI: 10.1109/IAS.1998.730240 ISBN: 978-0-7803-4943-8

## Description

This invention relates to a semiconductor switching string.

In power transmission networks alternating current (AC) power is typically converted to direct current (DC) power for transmission via overhead lines and/or undersea cables. This conversion removes the need to compensate for the AC capacitive load effects imposed by the transmission line or cable, and thereby reduces the cost per kilometre of the lines and/or cables. Conversion from AC to DC thus becomes cost-effective when power needs to be transmitted over a long distance.

The conversion of AC to DC power is also utilized in power transmission networks where it is necessary to interconnect AC electrical networks operating at different frequencies. In any such power transmission network high voltage direct current (HVDC) power converters, such as voltage source converters, are required at each interface between AC and DC power to effect the required conversion.

HVDC power converters typically employ switches to carry out rectification and inversion processes necessary to convert AC power to DC power and vice versa. These switches may include semiconductor switching elements, such as insulated gate bipolar transistors (IGBT), in order to improve the efficiency and switching capabilities of the power converter. However, the relatively low voltage rating of such semiconductor switching elements relative to the high voltages used in HVDC power transmission necessitates the use of a large number, e.g. many tens, of semiconductor switching elements connected in series within a switching string so that the combined voltage rating of the series-connected semiconductor switching elements is capable of supporting such high voltages.

EP 2 445 110 A1 discloses the use of intelligent gate driver units with distributed intelligence to control parallel-connected electrical switching devices like IGBTs. The purpose of the intelligent gate driver units in EP 2 445 110 A1 is to balance the currents or voltages of the switching devices and they may use master-slave or daisy chain control structures.

Gerster, C: "Fast High-power/High-voltage Switch Using Series-connected IGBTs with Active Gate-controlled Voltage-balancing" Applied Power Electronics Conference and Exposition, 1994 (ISBN: 978-0-7803-1456-6) discloses a method of gate-side voltage balancing for series-connected IGBTs.
Galluzzo, A, et.al: "Snubberless Balancement of Series Connected Insulated Gate Devices by a Novel Gate Control Strategy", Industry Application Conference, 1997 (ISBN: 978-0-7803-4067-1) discloses a method of balancing the voltage during switching transients of series-connected insulated gate devices such as MOSFETs or IGBTs.

According to an aspect of the invention there is provided a semiconductor switching string comprising a plurality of series-connected semiconductor switching elements,
each semiconductor switching element including:
   first and second terminals between which current flows from the first terminal to the second terminal when the semiconductor switching element is switched on;
   a third terminal to control the said current flowing from the first terminal to the second terminal; and
   a local switching controller operatively connected with the third terminal to control a terminal voltage between the first and second terminals, the semiconductor switching string being characterised in that,
each local switching controller of each semiconductor switching element being arranged in direct communication with at least each of its nearest neighbours in the semiconductor switching string and additionally arranged in indirect communication with the local switching controllers of a plurality of further semiconductor switching elements via the or each said local switching controller of the or each said semiconductor switching element with which it is arranged in direct communication,
wherein the local switching controller of a respective semiconductor switching element arranged in direct communication with one or more other local switching controllers is configured to receive directly from the or each said other local switching controller a feedback signal corresponding to the terminal voltage of the semiconductor switching element of the or each said other local switching controller,
each local switching controller being configured to vary during a switching transition the rate of change of terminal voltage of the semiconductor switching element with which it is operatively connected, such that
the degree to which each local switching controller varies the said rate of change of terminal voltage of the semiconductor switching element with which it is operatively connected is influenced to a primary extent by the or each feedback signal, corresponding to the terminal voltage of the or each semiconductor switching element with which its associated semiconductor switching element is arranged in direct communication, and to a secondary extent by the terminal voltage of each further semiconductor switching element with which its associated semiconductor switching element is arranged in indirect communication.

Having each local switching controller influenced to a primary extent by the terminal voltage of the or each other semiconductor switching element with which its associated semiconductor switching element is arranged in direct communication means that the semiconductor switching elements so arranged are able quickly to coordinate, e.g. equalize, their respective terminal voltages.

In addition, having the terminal voltage of each further semiconductor switching element with which its associated semiconductor switching element is arranged in indirect communication influence to a secondary extent each local switching controller reduces the need for sophisticated and complex communication between all semiconductor switching elements and, e.g. a single main central controller. It also avoids the need for a complex associated control regime that would otherwise be required to support such interconnectivity. Meanwhile it nevertheless provides each semiconductor switching element with a degree of feedback on the terminal voltage of a number of the other semiconductor switching elements such that the terminal voltage of those semiconductor switching elements can be coordinated so as to, e.g. in due course equalize.

Moreover, the inclusion of such local switching controllers achieves equal sharing of the voltage applied to the aforementioned semiconductor switching elements within the switching string, i.e. equal terminal voltages throughout the switching string, without the need for passive circuit elements such as snubbers which would otherwise slow down the switching on and off of the associated semiconductor switching elements and introduce switching losses into the switching string, as well as increase the overall space required to accommodate the switching string.

The provision of the feedback signal corresponding to the terminal voltage of the or each semiconductor switching element with which its associated semiconductor switching element is arranged in direct communication facilitates the fast coordination, i.e. equalizing, of the terminal voltages of various semiconductor switching elements within the semiconductor switching string.

Meanwhile, arranging the local switching controllers of two semiconductor switching elements in two-way communication with one another, i.e. in duplex communication, reduces the number of separate communication links that must be established within the semiconductor switching string, and so further optimises the configuration of the semiconductor switching string.

It will be appreciated that the semiconductor switching string according to the invention may be used in a variety of applications, each of which uses a plurality of series-connected semiconductor switching elements. Examples of such applications include, but are not limited to, a HVDC power converter.

Each local switching controller of each semiconductor switching element is arranged in either direct or indirect communication with each other local switching controller of each other semiconductor switching element in the semiconductor switching string.

Such an arrangement ensures that each semiconductor switching element receives a degree of feedback on the terminal voltage of all of the other semiconductor switching elements in the semiconductor switching string, such that the terminal voltage of all semiconductor switching elements can readily be coordinated so as to, e.g. in due course equalize.

Arranging the semiconductor switching elements in this manner results in extremely efficient communication between the semiconductor switching elements.

In another preferred embodiment of the invention the local switching controller of the semiconductor switching element at one end of the semiconductor switching string is arranged in direct communication with the local switching controller of the semiconductor switching element at the other end of the semiconductor switching string.

Such an arrangement results in a closed communication loop amongst the semiconductor switching elements which helps to speed the extent to which the terminal voltage of the various semiconductor switching elements can be coordinated, e.g. equalized.

Each local switching controller may be configured to compare the terminal voltage of the semiconductor switching element with which it is operatively connected with the terminal voltage of the or each other semiconductor switching element from which it receives the feedback signal.

Such an arrangement further facilitates the fast coordination, i.e. equalizing, of the terminal voltages of various semiconductor switching elements within the semiconductor switching string.

Each local switching controller may include a receiver module having a receiver unit to receive the plurality of feedback signals from the other semiconductor switching elements.

The inclusion of a receiver module which has such a receiver unit conveniently permits each local switching controller to, e.g. receive and decode a plurality of feedback signals received via respective communication conduits such as optical fibres.

Preferably the receiver module of each local switching controller includes an averaging unit to generate a terminal voltage average value corresponding to an average of the terminal voltages of the other semiconductor switching elements from which the feedback signal was received.

Such an averaging unit and the terminal voltage average value output thereby assists in driving the terminal voltage of the semiconductor switching element with which the local switching controller is operatively connected towards the average terminal voltage of each semiconductor switching element in the switching string, and thereby helps to achieve equal sharing of the voltage across each semiconductor switching element in the switching string.

Optionally the receiver module of each local switching controller includes a comparator unit to compare the terminal voltage average value generated by the averaging unit with the terminal voltage of the semiconductor switching element with which the local switching controller is operatively connected and thereafter produce a terminal voltage difference value which influences the rate of change of terminal voltage of the said semiconductor switching element with which the local switching controller is operatively connected.

Varying the rate of change of terminal voltage of each semiconductor switching element according to a corresponding terminal voltage difference value establishes a feedback loop which permits dynamic alteration of the rate of change of terminal voltage and additionally helps to drive the terminal voltage of each semiconductor switching element towards a common, equal level.

In a still further preferred embodiment of the invention each local switching controller includes a control module to control the rate of charge applied to the third terminal of the semiconductor switching element with which the local switching controller is operatively connected and thereby control the terminal voltage of the said semiconductor switching element with which the local switching controller is operatively connected.

Such an arrangement provides a convenient, reliable and repeatable way of controlling the terminal voltage of a respective semiconductor switching element, and thereby provides a reliable and repeatable way of varying the rate of change of terminal voltage of such a semiconductor switching element.

Optionally the control module of each local switching controller is configured to vary the rate of change of terminal voltage of the semiconductor switching element with which the local switching controller is operatively connected at predetermined time intervals during a switching transition.

Varying the rate of change of terminal voltage at predetermined time intervals during a switching transition helps to avoid undesirable oscillation of the terminal voltage.

Preferably the control module of each local switching controller is configured to:
apply a first predetermined rate of charge to the third terminal of the semiconductor switching element with which the local switching controller is operatively connected to change the terminal voltage of the said semiconductor switching element with which the local switching controller is operatively connected at a first rate when the said terminal voltage is below the average of the terminal voltages of the other semiconductor switching elements from which the feedback signal was received, and
apply a second predetermined rate of charge to the third terminal of the semiconductor switching element with which the local switching controller is operatively connected to change the terminal voltage of the said semiconductor switching element with which the local switching controller is operatively connected at a second rate different to the first rate when the said terminal voltage is above the average of the terminal voltages of the other semiconductor switching elements from which the feedback signal was received.

To switch off a given semiconductor switching element the control module of the corresponding local switching controller may be configured to:
increase the existing rate of charge applied to the third terminal of the semiconductor switching element with which the local switching controller is operatively connected to increase the rate of change of terminal voltage of the said semiconductor switching element with which the local switching controller is operatively connected when the said terminal voltage is below the average of the terminal voltages of the other semiconductor switching elements from which the feedback signal was received, and
decrease the existing rate of charge applied to the third terminal of the semiconductor switching element with which the local switching controller is operatively connected to decrease the rate of change of terminal voltage of the said semiconductor switching element with which the local switching controller is operatively connected when the said terminal voltage is above the average of the terminal voltages of the other semiconductor switching elements from which the feedback signal was received.

To switch on a given semiconductor switching element the control module of the corresponding local switching controller may be configured to:
decrease the existing rate of charge applied to the third terminal of the semiconductor switching element with which the local switching controller is operatively connected to decrease the rate of change of terminal voltage of the said semiconductor switching element with which the local switching controller is operatively connected when the said terminal voltage is below the average of the terminal voltages of the other semiconductor switching elements from which the feedback signal was received, and
increase the existing rate of charge applied to the third terminal of the semiconductor switching element with which the local switching controller is operatively connected to increase the rate of change of terminal voltage of the said semiconductor switching element with which the local switching controller is operatively connected when the said terminal voltage is above the average of the terminal voltages of the other semiconductor switching elements from which the feedback signal was received.

Each of the foregoing control arrangements desirably adjusts the rate of change of terminal voltage of the corresponding semiconductor switching element in a manner which can be readily tailored to the performance requirements of the associated application, e.g. a HVDC power converter, in which the associated semiconductor switching string is to be used.

Optionally the control module of each local switching controller is configured to vary the rate of charge applied to the third terminal of the semiconductor switching element with which the local switching controller is operatively connected according to when during the switching transition the charge is being applied.

Such an arrangement can be used to alter the rate of change of terminal voltage of the corresponding semiconductor switching element depending on the state of the switching transition, e.g. a faster rate of change towards the beginning of the switching transition and a slower rate of change towards the end of the switching transition.

In another preferred embodiment of the invention the control module of each local switching controller is configured at each predetermined time interval of a first switching transition to apply an established rate of charge to the third terminal of the semiconductor switching element with which the local switching controller is operatively connected, establish a revised rate of charge to be applied at the same time internal in a second subsequent corresponding switching transition, and apply the revised rate of charge at the said same time interval in the second subsequent corresponding switching transition.

Such an arrangement provides each control module with a learning functionality whereby each subsequent switching transition of the same type, i.e. on or off, is able to utilise information about the previous rate of charge, such that after several iterations the control module will provide an optimised terminal voltage switching profile that helps to speed convergence of the terminal voltages across all the semiconductor switching elements in the switching string towards a single, common value.

Preferably each local switching controller includes a transmitter module having a measuring unit to measure the terminal voltage of the semiconductor switching element with which the local switching controller is operatively connected.

The inclusion of such a measuring unit provides a convenient way of establishing locally the voltage between the first and second terminals of the corresponding semiconductor switching element.

The transmitter module of each local switching controller may include a transmitter unit to pass the feedback signal corresponding to the measured terminal voltage of the semiconductor switching element with which the local switching controller is operatively connected to the local switching controller of the or each other semiconductor switching element arranged in direct communication with the said semiconductor switching element with which the local switching controller is operatively connected.

The provision of such a transmitter unit readily facilitates the direct feedback of the state of the terminal voltage of a given semiconductor switching element to the local switching controller of the or each other semiconductor switching element arranged in direct communication with the said semiconductor switching element without the need for a sophisticated communication network.

Optionally the transmitter module of each local switching controller includes a transmitter unit to pass the measured terminal voltage of the semiconductor switching element with which the local switching controller is operatively connected to a comparator unit within the said local switching controller of which the transmitter module forms a part.

Such an arrangement additionally makes use of the measured terminal voltage to drive the actual terminal voltage of a given semiconductor switching element towards a common, equal value which is shared by each of the other semiconductor switching elements in the switching string.

There now follows a brief description of preferred embodiments of the invention, by way of non-limiting example, with reference being made to the following figures in which:
Figure 1 shows a schematic view of a semiconductor switching string according to a first embodiment of the invention;
Figure 2(a) illustrates schematically the manner in which a first semiconductor switching element within the semiconductor switching string shown in Figure 1 is arranged in communication with the other semiconductor switching elements in the semiconductor switching string;
Figure 2(b) shows a further schematic view of the manner in which the first semiconductor switching element is arranged in communication with the other semiconductor switching elements;
Figure 3(a) shows a schematic view of a first type of receiver module included within the semiconductor switching string shown in Figure 1;
Figure 3(b) shows a schematic view of a second type of receiver module possible in a semiconductor switching string according to a further embodiment of the invention;
Figure 4 shows a schematic view of a control unit included within the semiconductor switching string shown in Figure 1;
Figure 5(a) shows a schematic view of a first transmitter module included within the semiconductor switching string shown in Figure 1;
Figure 5(b) shows a schematic view of a second transmitter module possible in a semiconductor switching string according to a still further embodiment of the invention; and
Figure 6 shows how the terminal voltage of each of three semiconductor switching elements in the semiconductor switching string shown in Figure 1 varies during use of the switching string.

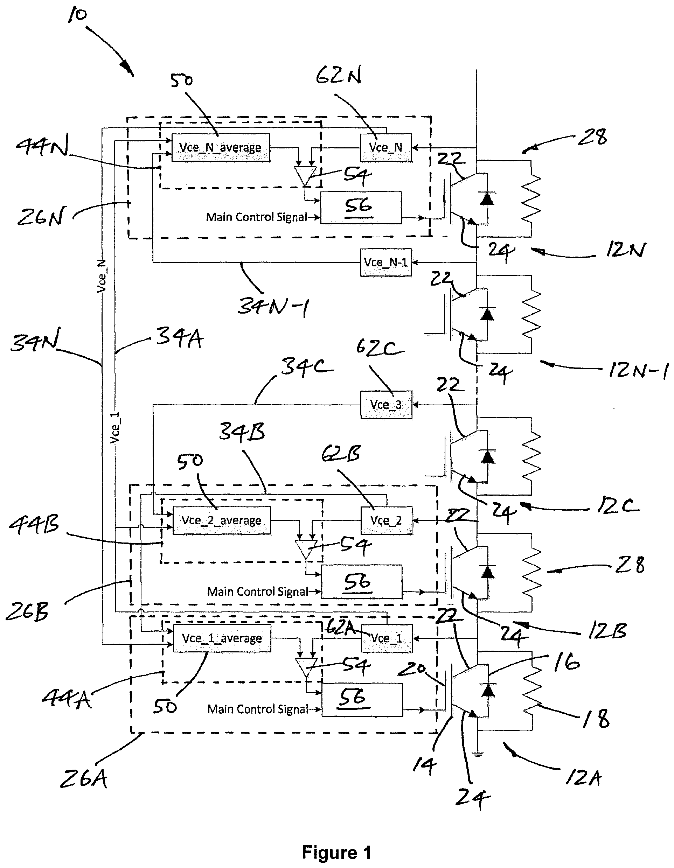

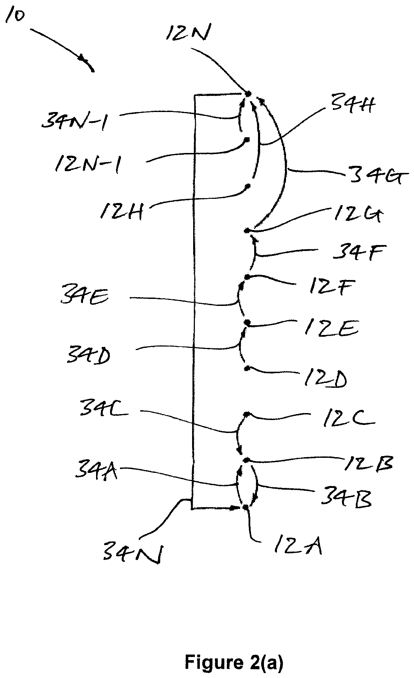

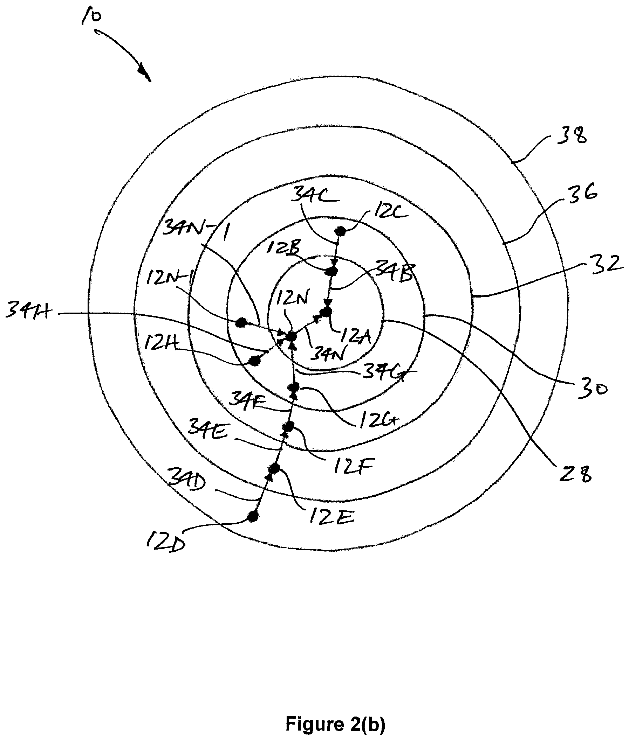

A semiconductor switching string according to a first embodiment of the invention is designated generally by reference numeral 10, as shown in Figures 1 and 2.

The semiconductor switching string 10 includes a plurality of series-connected semiconductor switching elements 12A, 12B, 12C, 12D, 12E, 12F, 12G, 12H, 12N-1, 12N, i.e. 1 to N such semiconductor switching elements where N is, for example, of the order of 10, 50, 100, 200, etc.

Each semiconductor switching element 12A, 12B, 12C, 12D, 12E, 12F, 12G, 12H, 12N-1, 12N includes a field effect controlled semiconductor device 14, such as an Insulated Gate Bipolar Transistor (IGBT), with an antiparallel diode 16 connected in parallel therewith. In the embodiment shown each semiconductor switching element 12A, 12B, 12C, 12D, 12E, 12F, 12G, 12H, 12N-1, 12N also includes a grading resistor 18 which is connected in parallel with each of the semiconductor device 14 and the antiparallel diode 16. In other embodiments of the invention, however, one or more of the semiconductor switching elements 12A, 12B, 12C, 12D, 12E, 12F, 12G, 12H, 12N-1, 12N may omit the grading resistor 18 and/or the antiparallel diode 16. Other embodiments of the invention may also include a different type of field effect controlled semiconductor device such as, for example, a metal-oxide-semiconductor field-effect-transistor (MOSFET), in particular a silicon carbide based MOSFET, a junction field effect transistor (JFET), a silicon carbide based junction field effect transistor (JFET), or a metal-oxide-semiconductor (MOS) controlled thyristor.

Each field effect controlled semiconductor device 14 has first and second terminals 22, 24 between which current flows from the first terminal 22 to the second terminal 24 when the semiconductor device 14 is switched on. Each semiconductor device 14 also includes a third terminal 20 to control the aforementioned flow of current from the first terminal 22 to the second terminal 24.

In the embodiment shown the first terminal 22 defines a collector terminal (which might also be known as a drain or anode terminal), the second terminal 24 is an emitter terminal (which might also be known as a source or cathode terminal), and the third terminal 20 defines a gate terminal (which might also be known as a base terminal).

In other embodiments of the invention (not shown) one or more of the semiconductor switching elements 12A, 12B, 12C, 12D, 12E, 12F, 12G, 12H, 12N-1, 12N may be formed from a plurality of series-connected semiconductor devices 14 which are connected to one another in such a manner that as a whole they similarly effectively present the same first, second and third terminals 22, 24, 20 mentioned above.

Each semiconductor switching element 12A, 12B, 12C, 12D, 12E, 12F, 12G, 12H, 12N-1, 12N also includes a corresponding local switching controller 26A, 26B, 26N (not all of which are illustrated in Figure 1) that is operatively connected with the third terminal 20 of the corresponding semiconductor switching element 12A, 12B, 12C, 12D, 12E, 12F, 12G, 12H, 12N-1, 12N. More particularly each local switching controller 26A, 26B, 26N is operatively connected with the third terminal 20 of the semiconductor device 14 included within the said corresponding semiconductor switching element 12A, 12B, 12C, 12D, 12E, 12F, 12G, 12H, 12N-1, 12N to control the terminal voltage of the said semiconductor device 14 , i.e. the voltage between the first and second terminals 22, 24 of the said semiconductor device 14, which in turn defines the terminal voltage of the corresponding semiconductor switching element 12A, 12B, 12C, 12D, 12E, 12F, 12G, 12H, 12N-1, 12N.

In the embodiment shown each semiconductor switching element 12A, 12B, 12C, 12D, 12E, 12F, 12G, 12H, 12N-1, 12N within the switching string 10 is arranged in direct communication with at least one other semiconductor switching element 12A, 12B, 12C, 12D, 12E, 12F, 12G, 12H, 12N-1, 12N, and is additionally arranged in indirect communication with a plurality of further semiconductor switching elements 12A, 12B, 12C, 12D, 12E, 12F, 12G, 12H, 12N-1, 12N via the or each said semiconductor switching element 12A, 12B, 12C, 12D, 12E, 12F, 12G, 12H, 12N-1, 12N with which it is arranged in direct communication.

Each local switching controller 26A, 26B, 26N is configured to vary during a switching transition, i.e. while switching the corresponding semiconductor device 14 on or off, the rate of change of terminal voltage of the semiconductor switching element 12A, 12B, 12C, 12D, 12E, 12F, 12G, 12H, 12N-1, 12N with which it is operatively connected.

The degree to which each local switching controller 26A, 26B, 26N varies the said rate of change of terminal voltage of the semiconductor switching element 12A, 12B, 12C, 12D, 12E, 12F, 12G, 12H, 12N-1, 12N with which it is operatively connected is influenced to a primary extent by the terminal voltage of the or each semiconductor switching element 12A, 12B, 12C, 12D, 12E, 12F, 12G, 12H, 12N-1, 12N with which its associated semiconductor switching element 12A, 12B, 12C, 12D, 12E, 12F, 12G, 12H, 12N-1, 12N, (i.e. the semiconductor switching element 12A, 12B, 12C, 12D, 12E, 12F, 12G, 12H, 12N-1, 12N with which it is operatively connected) is arranged in direct communication.

In addition, the degree to which each local switching controller 26A, 26B, 26N varies the said rate of change of terminal voltage of the semiconductor switching element 12A, 12B, 12C, 12D, 12E, 12F, 12G, 12H, 12N-1, 12N with which it is operatively connected is influenced to a secondary extent by the terminal voltage of each further semiconductor switching element 12A, 12B, 12C, 12D, 12E, 12F, 12G, 12H, 12N-1, 12N with which its associated semiconductor switching element 12A, 12B, 12C, 12D, 12E, 12F, 12G, 12H, 12N-1, 12N is arranged in indirect communication.

More particularly, and by way of example only, details of the manner in which the first semiconductor switching element 12A is arranged in communication with the other semiconductor switching elements 12B, 12C, 12D, 12E, 12F, 12G, 12H, 12N-1, 12N is described hereinbelow.

The first semiconductor switching element 12A is arranged in direct communication with the second semiconductor switching element 12B, and is arranged in indirect communication with the third switching element 12C via the aforementioned second semiconductor switching element 12B.

The first local switching controller 26A of the first semiconductor switching element 12A receives directly from the second semiconductor switching element 12B (with which it is arranged in direct communication) a second feedback signal 34B that corresponds to the terminal voltage V_{ce_2} of the second semiconductor switching element 12B.

The first local switching controller 26A is configured to compare the terminal voltage V_{ce_1} of the first semiconductor switching element 12A, i.e. the semiconductor switching element with which it is operatively connected, with the terminal voltage V_{ce_2} of the second semiconductor switching element 12B, i.e. the semiconductor switching element with which it is in direct communication, such that the terminal voltage V_{ce_2} of the second semiconductor switching element 12B is able directly to influence, i.e. influence to a primary extent, the terminal voltage V_{ce_1} of the first semiconductor switching element 12A, as described in more detail below.

Meanwhile, the second semiconductor switching element 12B is arranged in direct communication with the third semiconductor switching element 12C such that the second local switching controller 26B of the second semiconductor switching element 12B receives directly from the third semiconductor switching element 12C a third feedback signal 34C that corresponds to the terminal voltage V_{ce_3} of the third semiconductor switching element 12C.

As such the terminal voltage V_{ce_3} of the third semiconductor switching element 12C is able directly to influence, i..e influence to a primary extent, the rate of change of terminal voltage V_{ce_2} of the second semiconductor switching element 12B, and in turn (because of the aforementioned direct communication between the second semiconductor switching element 12B and the first semiconductor switching element 12A), thereby able to indirectly influence, i.e. influence to a secondary extent, the rate of change of terminal voltage V_{ce_1} of the first semiconductor switching element 12A.

The terminal voltage V_{ce_1} of the first semiconductor switching element 12A is therefore influenced to a primary extent by the terminal voltage V_{ce_2}, of the second semiconductor switching element 12B with which it is arranged in direct communication, and is influenced to a secondary extent by the terminal voltage V_{ce_3} of the third semiconductor switching element 12C with which it is arranged in indirect communication via the second semiconductor switching element 12B.

The first semiconductor switching element 12A is also arranged in direct communication with the nth semiconductor switching element 12N and thereby receives directly from the nth semiconductor switching element an nth feedback signal 34N corresponding to the terminal voltage V_{ce_N} of the said nth semiconductor switching element 12N.

Like the second semiconductor switching element 12B, the nth semiconductor switching element 12N is the immediate nearest neighbour to the first semiconductor switching element 12A, at least from a control perspective when the first and nth semiconductor switching elements 12A, 12N are considered in a logical representation of the switching string 10 to lie next to one another. Arranging a given semiconductor switching element in direct communication with one or more of its immediate nearest neighbours and/or those next-nearest neighbours is desirable since it represents the most efficient way of establishing communication between those said semiconductor switching elements.

The first local switching controller 26A of the first semiconductor switching element 12A is configured to additionally compare the terminal voltage V_{ce_1} of the first semiconductor switching element 12A with the terminal voltage V_{ce_N} of the nth semiconductor switching element 12N.

As a result the terminal voltage V_{ce_N} of the nth semiconductor switching element 12N is also able to directly influence, i.e. influence to a primary extent, the rate of change of terminal voltage of the first semiconductor switching element 12A.

Furthermore, the nth semiconductor switching element 12N is arranged in direct communication with three other seventh, eighth and nth-1 semiconductor switching elements 12G, 12H, 12N-1 and so it receives a respective feedback signal 34G, 34H, 34N-1 from each such further semiconductor switching element 12G, 12H, 12N-1 whereby its terminal voltage V_{ce_N} is influenced directly, i.e. to a primary extent, by the terminal voltage V_{ce_N-1} of each of these three further semiconductor switching elements 12G, 12H, 12N-1.

The rate of change of terminal voltage V_{ce_1} of the first semiconductor switching element 12A is, therefore, influenced to a secondary extent by the terminal voltage V_{ce_N-1} of each of the three further semiconductor switching elements 12G, 12H, 12N-1, i.e. via the effect that the terminal voltage V_{ce_N-1} of each of the three further semiconductor switching elements 12G, 12H, 12N-1 has on the terminal voltage V_{ce_N} of the nth semiconductor switching element 12N which provides a direct feedback signal 34N to the first semiconductor switching element 12A.

Moreover, the seventh semiconductor switching element 12G is arranged in direct communication with a sixth semiconductor switching element 12F whereby it receives directly from the sixth semiconductor switching element 12F a sixth feedback signal 34F corresponding to the terminal voltage of the sixth semiconductor switching element 12F.

The terminal voltage of the sixth semiconductor switching element 12F is directly influenced, i.e. influenced to a primary extent, by the terminal voltage of a fifth semiconductor switching element 12E with which it is arranged in direct communication, and is indirectly influenced, i.e. influenced to a secondary extent, by the terminal voltage of a fourth semiconductor switching element 12D with which it is arranged in indirect communication via the fifth semiconductor switching element 12E.

The terminal voltage of each of the fourth, fifth and sixth semiconductor switching elements 12D, 12E, 12F influences the terminal voltage of the seventh semiconductor switching element 12G, which in turn (as described above) ultimately influences the rate of change of the terminal voltage V_{ce_1} of the first semiconductor switching element 12A, i.e. via the nth semiconductor switching element 12N.

In this manner each of the aforementioned semiconductor switching elements 12D, 12E, 12F, 12G, 12H, 12N-1 is arranged in indirect communication with the first semiconductor switching element 12A, such that their respective terminal voltages influence to a secondary extent the rate of change of terminal voltage V_{ce_1} of the first semiconductor switching element 12A.

It follows that a series of control groups are established with respect to the first semiconductor switching element 12A within the semiconductor switching string 10, as is best illustrated in Figure 2(b).

A first order control group 28 includes the first semiconductor switching element 12A and each of the second and nth semiconductor switching elements 12B, 12N with which it is arranged in direct communication.

A second order control group 30 includes the third semiconductor switching element 12C which is arranged in direct communication with the second semiconductor switching element 12B, the seventh, eighth and nth-1 semiconductor switching elements 12G, 12H, 12N-1 that are arranged in direct communication with the nth semiconductor switching element 12N, as well as each of the first, second and nth semiconductor switching elements 12A, 12B, 12N which define the first order control group 28.

A third order control group 32 includes the sixth semiconductor switching element 12F which is arranged in direct communication with the fifth semiconductor switching element 12E, together with all of the semiconductor switching elements that are in the first and second order control groups 28 ,30.

Additional, higher order control groups 36, 38 successively encompass further semiconductor switching elements 12E, 12D until all of the semiconductor switching elements 12A, 12B, 12C, 12D, 12E, 12F, 12G, 12H, 12N-1, 12N in the semiconductor switching string 10 fall within at least one such control group. In this way the terminal voltage of each of the other semiconductor switching elements 12B, 12C, 12D, 12E, 12F, 12G, 12H, 12N-1, 12N is able to influence either to a primary extent, i.e. directly, or to a secondary extent, i.e. indirectly, the terminal voltage of the first semiconductor switching element 12A.

Further communication (not shown) is provided with respect to the remaining semiconductor switching elements 12B, 12C, 12D, 12E, 12F, 12G, 12N-1, 12N such that the rate of change of terminal voltage of each such remaining semiconductor switching element 12B, 12C, 12D, 12E, 12F, 12G, 12N-1, 12N can be influenced, in a similar manner as described above, to a primary extent by the terminal voltage of the or each semiconductor switching element with which it is arranged in direct communication and to a secondary extent by the terminal voltage of the semiconductor switching elements with which it is arranged in indirect communication.

In all such instances the communication between respective semiconductor switching elements 12A, 12B, 12C, 12D, 12E, 12F, 12G, 12H, 12N-1, 12N may take the form of duplex communication, so as to provide a degree of overlap in the respective communication channels between such semiconductor switching elements 12A, 12B, 12C, 12D, 12E, 12F, 12G, 12H, 12N-1, 12N.

More detail regarding the manner in which each local switching controller 26A, 26B, 26N varies the rate of change of terminal voltage of the corresponding semiconductor switching element 12A, 12B, 12C, 12D, 12E, 12F, 12G, 12N-1, 12N with which it is operatively connected, i.e. under the influence to a primary extent or to a secondary extent by the terminal voltage of other semiconductor switching elements, is described hereinbelow by way of example only with reference to the first local switching controller 26A.

Each local switching controller 26A, 26B, 26N includes a corresponding first receiver module 44A, 44B, 44N.

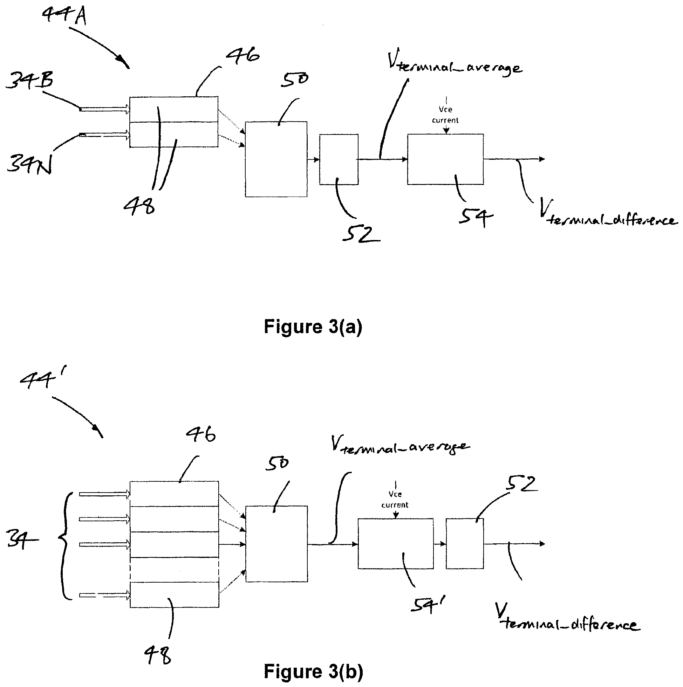

As shown in more detail in Figure 3(a), the first receiver module 44A the first local switching controller 26A has a receiver unit 46 which includes a respective receiver/decoder block 48 to receive an individual feedback signal 34B, 34N provided by the second and nth semiconductor switching elements 12B, 12N with which the first semiconductor switching element 12A is arranged in direct communication.

The first receiver module 44A also includes an averaging unit 50 to generate a terminal voltage average value V_{terminal_average} which corresponds to an average of the terminal voltages V_{ce_2}, V_{ce_N} of the second and nth semiconductor switching elements 12B, 12N. The terminal voltage average value V_{terminal_average} is converted to an analogue signal by a digital to analogue converter (DAC) 52.

In other embodiments of the invention (not shown) each individual feedback signal 34B, 34N may include status information regarding the corresponding semiconductor switching element 12B, 12N, such as whether the corresponding semiconductor device 14 is operable or damaged, and the averaging unit 50 is able to take this status information into account when generating the terminal voltage average value V_{terminal_average}. In still further embodiments of the invention, the averaging unit 50 may employ additional algorithms to estimate the validity of each individual feedback signal and thereafter discard some of the feedback signal information accordingly. In each instance, such further functionality provides the associated semiconductor switching string with an increased degree of redundancy since errors in individual feedback signals do not affect the overall performance of the said semiconductor switching strings.

In addition to the foregoing, the first receiver module 44A in the embodiment shown also includes an analogue comparator unit 54 which compares the terminal voltage average value V_{terminal_average} generated by the averaging unit 50 with the terminal voltage V_{ce_1} of the first semiconductor switching element 12A and thereafter produces a terminal voltage difference value V_{terminal_difference} which influences the rate of change of terminal voltage V_{ce_1} of the first semiconductor switching element 12A.

In other embodiments of the invention (not shown) one or more of the local switching controllers 26A, 26B, 26N may include a second receiver module 44', as shown in Figure 3(b).

The second receiver module 44' similarly includes a receiver unit 46 with respective receiver/decoder blocks 48 to receive individual feedback signals and an averaging unit 50 to generate a terminal voltage average value V_{terminal_average}. However, the second receiver module 44 differs from the aforementioned first receiver module 44A, 44B, 44N in that it includes a digital comparator unit 54' which similarly produces a terminal voltage difference value V_{terminal_difference} but which is then passed through a DAC 52.

The terminal voltage difference value V_{terminal_difference} which is produced by the analogue comparator unit 54 (or indeed as produced by the digital comparator unit 54') influences the degree to which first local switching controller 26A varies rate of change of terminal voltage V_{ce_1} of the first semiconductor switching element 12A.

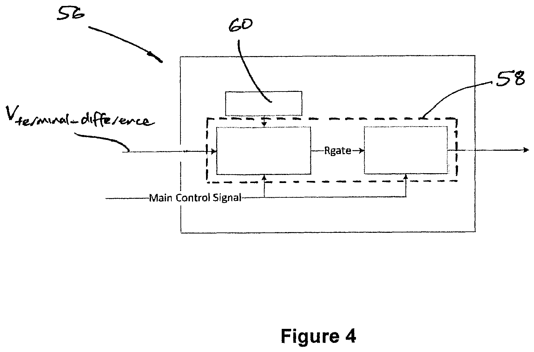

To achieve such variation of the rate of change of terminal voltage, the first local switching controller 26A also includes a control module 56, as shown in Figure 4, to control the rate of charge applied to the third terminal 20 of the first semiconductor switching element 12A, with which the first local switching controller 26A is operatively connected, and thereby control the terminal voltage V_{ce_1} of the said first semiconductor switching element 12A.

In the embodiment shown the control module 56 of the first local switching controller 26A (and indeed each other local switching controller 26B, 26N) utilises an active gate resistor drive configuration 58 to control the rate of charge applied to the third terminal 20 of the corresponding first semiconductor switching element 12A, although in other embodiments of the invention one or more of the control modules 56 may instead utilise a current source control configuration or a voltage source control configuration to govern the rate of charge applied to the corresponding third terminal 20.

In the embodiment shown, the control module 56 of the first local switching controller 26A, changes a gate resistor value R_{gate} based on the terminal voltage difference value V_{terminal_difference} received from the analogue comparator unit 54 within the first local switching controller 26A.

The control module 56 of the first local switching controller 26A changes the corresponding gate resistor value R_{gate} at predetermined time intervals during a switching transition, i.e. while switching the corresponding semiconductor device 14 on or off, and thereby varies the rate of change of terminal voltage V_{ce_1} of the first semiconductor switching element 12A at the same predetermined time intervals. The control module 56 includes a local clock unit 60 to facilitate updating of the gate resistor value R_{gate} at the required predetermined time intervals, although in other embodiments of the invention (not shown) the clock unit 60 may be located elsewhere, e.g. within the first local switching controller 26A.

More particularly, in the embodiment shown, the control module 56 of the first local switching controller 26A is configured when switching off the first semiconductor switching element 12A to modify the existing rate of change of terminal voltage V_{ce_1}, i.e. by decreasing the gate resistor value R_{gate}, to increase the existing rate of charge applied to the third terminal 20 of the first semiconductor switching element 12A, and thereby cause an increase in the rate of change of terminal voltage V_{ce_1} of the said first semiconductor switching element 12A, when the terminal voltage difference value V_{terminal_difference} received from the analogue comparator unit 54 indicates that the terminal voltage V_{ce_1} of the said first semiconductor switching element 12A is below the terminal voltage average value V_{terminal_average} generated by the averaging unit 50 of the first local switching controller 26A, i.e. below the average of the terminal voltages V_{ce_2}, V_{ce_N} of the second and nth semiconductor switching elements 12B, 12N.

The control module 56 of the first local switching controller 26A is also, when switching off the first semiconductor switching element 12A, configured to further modify the existing rate of change of terminal voltage V_{ce_1}, i.e. by increasing the gate resistor value R_{gate}, to decrease the existing rate of charge applied to the third terminal 20 of the first semiconductor switching element 12A, and thereby cause a decrease in the rate of change of terminal voltage V_{ce_1} of the said first semiconductor switching element 12A, when the terminal voltage difference value V_{terminal_difference} received from the analogue comparator unit 54 indicates that the terminal voltage V_{ce_1} of the said first semiconductor switching element 12A is above the terminal voltage average value V_{terminal_average} generated by the averaging unit 50 of the first local switching controller 26A, i.e. above the average of the terminal voltages V_{ce_2}, V_{ce_N} of the second and nth semiconductor switching elements 12B, 12N.

When switching on the first semiconductor switching element 12A the control module 56 of the corresponding first local switching controller 26A is configured to modify the existing rate of change of terminal voltage in the opposite sense to those described above, i.e.
- by increasing the gate resistor value R_{gate}, to decrease the existing rate of charge applied to the third terminal 20 of the first semiconductor switching element 12A, and thereby cause a decrease in the rate of change of terminal voltage V_{ce_1} of the said first semiconductor switching element 12A, when the terminal voltage difference value V_{terminal_difference} received from the analogue comparator unit 54 indicates that the terminal voltage of the said first semiconductor switching element 12A is below the terminal voltage average value V_{terminal_average} generated by the averaging unit 50 of the first local switching controller 26A, i.e. below the average of the terminal voltages V_{ce_2}, V_{ce_N} of the second and nth semiconductor switching elements 12B, 12N; and
- by decreasing the gate resistor value R_{gate}, to increase the existing rate of charge applied to the third terminal 20 of the first semiconductor switching element 12A, and thereby cause an increase in the rate of change of terminal voltage V_{ce_1} of the said first semiconductor switching element 12A, when the terminal voltage difference value V_{terminal_difference} received from the analogue comparator unit 54 indicates that the terminal voltage V_{ce_1} of the said first semiconductor switching element 12A is above the terminal voltage average value V_{terminal_average} generated by the averaging unit 50 of the first local switching controller 26A, i.e. above the average of the terminal voltages V_{ce_2}, V_{ce_N} of the second and nth semiconductor switching elements 12B, 12N.

In other embodiments of the invention (not shown) the control module 56 of each local switching controller 26A, 26B, 26N may instead be configured more simply to instigate a predetermined rate of change of terminal voltage V_{ce_1} depending on the nature of the terminal voltage difference value V_{terminal_difference} received from the analogue comparator unit 54.

More particularly, in such other embodiments of the invention the control module 56 of each local switching controller 26A, 26B, 26N may instead be configured to change the gate resistor value R_{gate} to a first predetermined level, in order to apply a first predetermined rate of charge to the third terminal 20 of the semiconductor switching element 12A, 12B, 12C, 12D, 12E, 12F, 12G, 12N-1, 12N with which the local switching controller 26A, 26B, 26N is operatively connected, and thereby change the terminal voltage of the said semiconductor switching element 12A, 12B, 12C, 12D, 12E, 12F, 12G, 12N-1, 12N with which the local switching controller 26A, 26B, 26N is operatively connected at a first rate when the said terminal voltage is below the average of the terminal voltages of the semiconductor switching elements 12A, 12B, 12C, 12D, 12E, 12F, 12G, 12N-1, 12N from which a feedback signal is received, and to change the gate resistor value R_{gate} to a second predetermined level, in order to apply a second predetermined rate of charge to the third terminal 20 of the semiconductor switching element 12A, 12B, 12C, 12D, 12E, 12F, 12G, 12N-1, 12N with which the local switching controller 26A, 26B, 26N is operatively connected, and thereby change the terminal voltage of the said semiconductor switching element 12A, 12B, 12C, 12D, 12E, 12F, 12G, 12N-1, 12N with which the local switching controller 26A, 26B, 26N is operatively connected at a second rate different to the first rate when the said terminal voltage is above the average of the terminal voltages of the other semiconductor switching elements 12A, 12B, 12C, 12D, 12E, 12F, 12G, 12N-1, 12N from which a feedback signal is received.

In another embodiment of the invention (not shown) the control module 56 of each local switching controller 26A, 26B, 26N may additionally be configured to vary the gate resistor value R_{gate} in order to correspondingly vary the rate of charge applied to the third terminal 20 of the semiconductor switching element 12A, 12B, 12C, 12D, 12E, 12F, 12G, 12N-1, 12N with which the local switching controller 26A, 26B, 26N is operatively connected according to when during the switching transition the rate of charge is being applied to the said third terminal 20.

In still further other embodiments of the invention (not shown) the control module 56 of each local switching controller 26A, 26B, 26N may instead be configured to implement a learning functionality.

More particularly, each control module 56 in such other embodiments of the invention may be configured, at each predetermined time interval of a first switching transition, i.e. a first switching off or switching on transition, to set an initial gate resistor value R_{gate} so as to apply an initial rate of charge to the third terminal 20 of the semiconductor switching element 12A, 12B, 12C, 12D, 12E, 12F, 12G, 12N-1, 12N with which the local switching controller 26A, 26B, 26N is operatively connected, then establish a revised gate resistor value R_{gate} corresponding to a revised rate of charge to be applied at the same time internal in a second subsequent switching transition, i.e. a second corresponding switching off or switching on transition, and to then change the gate resistor value to the revised gate resistor value so as to apply the revised rate of charge at the said same time interval in the second subsequent switching transition. Each such control module 56 may be further configured to repeat the aforementioned steps a plurality of times during further subsequent corresponding switching transitions.

In each of the aforementioned embodiments once the switching transition, i.e. switching a given semiconductor switching element 12A, 12B, 12C, 12D, 12E, 12F, 12G, 12N-1, 12N on or off, is completed each control module 56 reverts back to a standard gate resistor value commensurate with the switching transition, i.e. on or off, which is expected next.

In addition, each such control module 56 may make use of a main control signal from a main central controller (not shown) to initiate a switching transition. Each may also make use of a similar main control signal from the main central controller to indicate when a given switching transition is complete. Other such control modules 56 may, alternatively, estimate completion of a switching transition based on current or voltage measurements within the corresponding semiconductor switching element 12A, 12B, 12C, 12D, 12E, 12F, 12G, 12N-1, 12N or use a fixed time value.

In yet other embodiments of the invention data relating to the gate resistor values utilised during a switching transition may be communicated to a main central controller, or some other higher level controller, to permit analysis and optimisation to further improve the performance of the associated semiconductor switching string. Furthermore, the results of this analysis and optimisation may be communicated back to the corresponding semiconductor switching element, e.g. in the form of a revised switching profile, to further assist in improving the said performance.

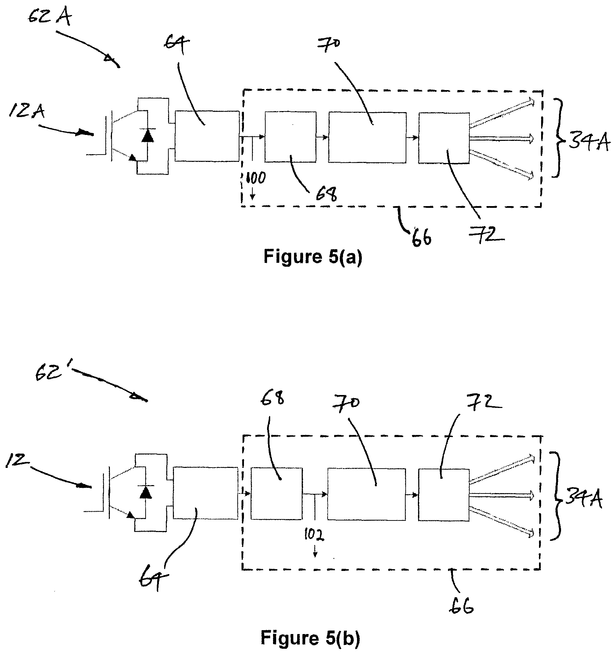

Returning to the embodiment of the semiconductor switching string 10 shown in Figure 1, and by way of example with reference to the first semiconductor switching element 12A, the first local switching controller 26A additionally includes an first transmitter module 62A, as shown in Figure 5(a).

The first transmitter module 62A has a measuring unit 64 to measure the terminal voltage V_{ce_1} of the first semiconductor switching element 12A, i.e. the corresponding semiconductor switching element 12A with which the first local switching controller 26A operatively connected. In the embodiment shown the measuring unit 64 takes the form of a voltage divider circuit which includes the grading resistor 18 connected in parallel with the first semiconductor switching element 12A. The output 100 of such a voltage divider circuit is a scaled down representation of the terminal voltage V_{ce_1} of the first semiconductor switching element 12A, i.e. the terminal voltage V_{ce_1} of the corresponding semiconductor device 14.

The first transmitter module 62A of the first local switching controller 26A also includes a transmitter unit 66 which both:
(i) passes a first feedback signal 34A corresponding to the measured terminal voltage V_{ce_1} of the first semiconductor switching element 12A to the corresponding local switching controller 26B, 26N of each of the second and nth semiconductor switching elements 12B, 12N which are arranged in direct communication with the first semiconductor switching element 12A; and
(ii) passes the measured terminal voltage V_{ce_1} of the first semiconductor switching element 12A to the analogue comparator unit 54 within the first local switching controller 26A of which the first transmitter module 62A forms a part.

More particularly, in the embodiment shown, the transmitter unit 66 includes an analogue to digital converter (ADC) 68 to convert the output 100 of the voltage divider circuit into a digital form before it is encoded in a desired format by an encoder unit 70. During such encoding information about the status if the first semiconductor switching element 12A, i.e. operative or damaged, can be included. Once so encoded the resulting message is then passed to a splitter unit 72 which passes the message, i.e. the first feedback signal 34A corresponding to the measured terminal voltage V_{ce_1} of the first semiconductor switching element 12A, via optical fibre, to the corresponding local switching controller 26B, 26N of each of the second and nth semiconductor switching elements 12B, 12N that are arranged in direct communication with the first semiconductor switching element 12A.

Meanwhile the transmitter unit 66 also passes the output 100 of the voltage divider circuit to the analogue comparator unit 54 within the first local switching controller 26A.

Each of the other local switching controllers 26B, 26N in the embodiment shown includes a corresponding analogue transmitter module 62B, 62N which is similarly configured according to which other semiconductor switching elements the semiconductor switching element of which it forms a part is arranged in direct communication with.

Figure 5(b) shows a second transmitter module 62' which is very similar to the aforementioned first transmitter module 62A, 62B, 62N, and which may be included in other embodiments of the invention (not shown).

The second transmitter module 62' similarly includes a measuring unit 64 and a transmitter unit 66. The second transmitter module 62' differs from the first transmitter module 62A, 62B, 62N in that the output 100 of the voltage divider circuit is passed in the form of an output 102 of the ADC 68 to a corresponding digital comparator unit 54' (within the corresponding local switching controller 26A, 26B, 26N of which the second transmitter module 62' forms a part) after passing through the ADC 68.

In use the semiconductor switching string 10 shown in Figure 1 operates as follows.

The first semiconductor switching element 12A is arranged in direct communication with the second semiconductor switching element 12B and receives directly therefrom a second feedback signal 34B corresponding to the terminal voltage V_{ce_2} across the first and second terminals 22, 24 of the second semiconductor switching element 12B.

The first semiconductor switching element 12A is also arranged in direct communication with the nth semiconductor switching element 12N, and so similarly receives an nth feedback signal 34N from the nth semiconductor switching element 12N which corresponds to the terminal voltage V_{ce_N} across the first and second terminals 22, 24 of the nth semiconductor switching element.

These feedback signals 34B, 34N are used by the first receiver module 44A of the first local switching controller 26A, and more particularly the averaging unit 50 within the first receiver module 44A, to calculate a first terminal voltage average value V_{ce_1_average} for use by the analogue comparator unit 54 of the first local switching controller 26A.

The first terminal voltage average value V_{ce_1_average} is compared with the terminal voltage V_{ce_1} of the first semiconductor switching element 12A, i.e. as output by the voltage divider circuit in the measuring unit 64 of the first transmitter module 62A within the first local switching controller 26A, by the analogue comparator unit 54 of the first local switching controller 26A and the result, i.e. a first terminal voltage difference value V_{terminal_difference}, is fed into the control module 56 of the first local switching controller 26A.

Based on the difference between first terminal voltage average value V_{ce_1_average} and the measured terminal voltage V_{ce_1} of the first semiconductor switching element 12A, the control module 56 dynamically changes the charging condition of the third terminal 20 of the first semiconductor switching element 12A by altering the gate resistor value R_{gate} accordingly during a switching transition, as initiated by a main control signal from a main central controller.

The terminal voltage V_{ce_1} of the first semiconductor switching element 12A is therefore influenced to a primary extent by the terminal voltages V_{ce_2}, V_{ce_N} of the second and nth semiconductor switching elements 12B. 12N.

The terminal voltage V_{ce_2} of the second semiconductor switching element 12B is itself influenced directly, i.e. to a primary extent, by the terminal voltage V_{ce_3} of the third semiconductor switching element 12C, and so the driving condition for the terminal voltage V_{ce_1} of the first semiconductor switching element 12A is influenced to a secondary extent, i.e. indirectly, by the terminal voltage V_{ce_3} of the third semiconductor switching element 12C.

Meanwhile the terminal voltage V_{ce_N} of the nth semiconductor switching element 12N is influenced directly, i.e. to a primary extent, by the terminal voltage V_{ce_N-1} of each of the three further semiconductor switching elements 12G, 12H, 12N-1 with which it is arranged in direction communication. In addition, the terminal voltage of the seventh semiconductor switching element 12G is itself directly influenced, i.e. influenced to a primary extent, by the terminal voltage of the sixth semiconductor switching element 12F, which is in turn influenced by the terminal voltage of each of the other semiconductor switching elements 12D, 12E.

In this way the driving condition for the terminal voltage V_{ce_1} of the first semiconductor switching element 12A is influenced to a secondary extent, i.e. via the direct nth feedback signal 34N from the nth semiconductor switching element 12N, by the terminal voltage of each of the other semiconductor switching elements 12D, 12E, 12F, 12G, 12H, 12N-1, 12N.

Such primary and secondary influencing of the terminal voltage V_{ce_1} of the first semiconductor switching element 12A, and similar operation of the local switching controllers 26B, 26N in the other semiconductor switching elements 12B, 12C, 12D, 12E, 12F, 12G, 12H, 12N-1, 12N in the semiconductor switching string 10, results in the terminal voltage of all semiconductor switching elements 12A, 12B, 12C, 12D, 12E, 12F, 12G, 12H, 12N-1, 12N within the semiconductor switching string 10 converging to an equalized, common value.

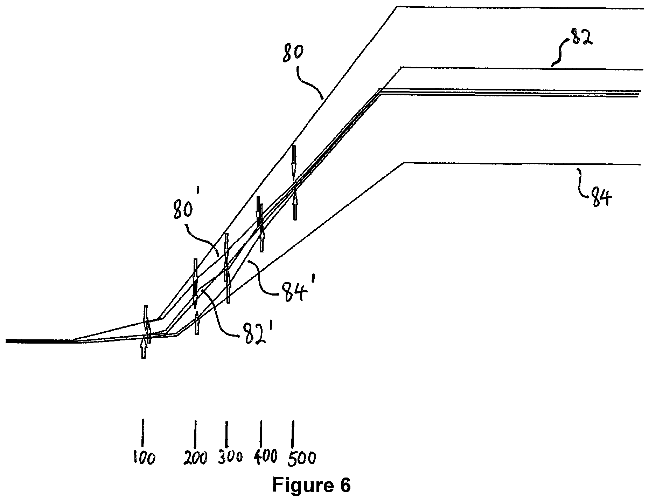

Such equalisation of the terminal voltage of each semiconductor switching element 12A, 12B, 12C, 12D, 12E, 12F, 12G, 12H, 12N-1, 12N is illustrated in Figure 6, using a turn off switching transition by way of example for the first, second and nth semiconductor switching elements 12A, 12B, 12N shown in Figure 1.

A first trace 80, 82, 84 for each semiconductor switching element 12A, 12B, 12N, respectively, shows how the terminal voltage of each element 12A, 12B, 12N would vary during turn off in the absence of respective local switching controllers 26A, 26B, 26N according to the invention.

A second trace 80', 82' and 84' shows how the terminal voltage of each semiconductor switching element 12A, 12B, 12N is controlled when respective local switching controllers 26A, 26B 26N according to the invention are employed.

More particularly, turn off starts normally, with each semiconductor switching element 12A switching at its own pace. As a voltage imbalance develops between terminal voltages of the semiconductor switching elements 12A, 12B, 12N the output of the analogue comparator unit 54 of each corresponding local switching controller 26A, 26B, 26N feeds this difference to the corresponding control module 56.

At the beginning of the turn off the control module 56 of each corresponding local switching controller 26A, 26B 26N sets the same gate resistor value R_{gate}.

At a first predetermined time interval 100 during the turn off switching transition the respective second and nth local switching controllers 26B, 26N operatively connected with the second and nth semiconductor switching elements 12B, 12N establish that the said second and nth semiconductor switching elements 12B, 12N are switching slower than average and the first local switching controller 26A establishes that the first semiconductor switching element 12A is switching faster than average.

This, in turn, will cause the corresponding control modules 56 to adjust the corresponding gate resistor values in order to alter the rate of charge applied to the corresponding third terminals 20. For the second and nth semiconductor switching elements 12B, 12N the gate resistor value R_{gate} will be decreased and for the first semiconductor switching element 12A the gate resistor value R_{gate} will be increased. As a result the switching of the second and nth semiconductor switching elements 12B, 12N will speed up and the switching of the first semiconductor switching element 12A will slow down.

At a second predetermined time interval 200, the first and second local switching controllers 26A, 26B establish that the corresponding first and second semiconductor switching elements 12A, 12B are fast and the nth local switching controller 26N establishes that the nth semiconductor switching element 12N is slow. Each of the corresponding control modules 56 will again then adjust the gate resistor value R_{gate} to correct for the deviation from the average terminal voltage, i.e. the average switching speed. Accordingly, with time the terminal voltage of each semiconductor switching element 12A, 12B 12N converges at one level and each control module 56 will have established its own corresponding gate resistor value R_{gate}.

It is envisaged that, in other embodiments of the invention, each semiconductor switching element may be arranged in either direct or indirect communication with each other semiconductor switching element in the semiconductor switching string. Such an arrangement ensures that each semiconductor switching element receives a degree of feedback on the terminal voltage of all of the other semiconductor switching elements in the semiconductor switching string, such that the terminal voltage of all semiconductor switching elements can readily be coordinated so as to, e.g. in due course equalize.

## Claims

1. A semiconductor switching string (10) comprising a plurality of series-connected semiconductor switching elements (12A, 12B, 12C, 12D, 12E, 12F, 12G, 12H, 12N-1, 12N),
each semiconductor switching element (12A, 12B, 12C, 12D, 12E, 12F, 12G, 12H, 12N-1, 12N including:
first and second terminals (22, 24) between which current flows from the first terminal (22) to the second terminal (24) when the semiconductor switching element (12A, 12B, 12C, 12D, 12E, 12F, 12G, 12H, 12N-1, 12N) is switched on;
a third terminal (20) to control the said current flowing from the first terminal (22) to the second terminal (24); and
a local switching controller (26A, 26B, 26N) operatively connected with the third terminal (20) to control a terminal voltage between the first and second terminals (22, 24), such that the voltages applied to the semiconductor switching elements within the switching string are coordinated, the semiconductor switching string being **characterised in that**
each local switching controller (26A, 26B, 26N) of each semiconductor switching element (12A, 12B, 12C, 12D, 12E, 12F, 12G, 12H, 12N-1, 12N) being arranged in direct communication with at least each of its nearest neighbours in the semiconductor switching string and additionally arranged in indirect communication with the local switching controllers (26A, 26B, 26N) of a plurality of further semiconductor switching elements (12A, 12B, 12C, 12D, 12E, 12F, 12G, 12H, 12N-1, 12N) via the or each said local switching controller (26A, 26B, 26N) of the or each said semiconductor switching element (12A, 12B, 12C, 12D, 12E, 12F, 12G, 12H, 12N-1, 12N) with which it is arranged in direct communication,
wherein the local switching controller of a respective semiconductor switching element arranged in direct communication with one or more other local switching controllers is configured to receive directly from the or each said other local switching controller a feedback signal corresponding to the terminal voltage of the semiconductor switching element of the or each said other local switching controller,
each local switching controller (26A, 26B, 26N) being configured to vary during a switching transition the rate of change of terminal voltage of the semiconductor switching element (12A, 12B, 12C, 12D, 12E, 12F, 12G, 12H, 12N-1, 12N) with which it is operatively connected, such that
the degree to which each local switching controller (26A, 26B, 26N) varies the said rate of change of terminal voltage of the semiconductor switching element (12A, 12B, 12C, 12D, 12E, 12F, 12G, 12H, 12N-1, 12N) with which it is operatively connected is influenced to a primary extent by the or each feedback signal corresponding to the terminal voltage of the or each semiconductor switching element (12A, 12B, 12C, 12D, 12E, 12F, 12G, 12H, 12N-1, 12N) with which its associated semiconductor switching element (12A, 12B, 12C, 12D, 12E, 12F, 12G, 12H, 12N-1, 12N) is arranged in direct communication, and to a secondary extent by the terminal voltage of each further semiconductor switching element (12A, 12B, 12C, 12D, 12E, 12F, 12G, 12H, 12N-1, 12N) with which its associated semiconductor switching element (12A, 12B, 12C, 12D, 12E, 12F, 12G, 12H, 12N-1, 12N) is arranged in indirect communication.

2. A semiconductor switching string (10) according to Claim 1 wherein each local switching controller (26A, 26B, 26N) of each semiconductor switching element (12A, 12B, 12C, 12D, 12E, 12F, 12G, 12H, 12N-1, 12N) is arranged in either direct or indirect communication with each other local switching controller (26A, 26B, 26N) of each other semiconductor switching element (12A, 12B, 12C, 12D, 12E, 12F, 12G, 12H, 12N-1, 12N) in the semiconductor switching string (10).

3. A semiconductor switching string (10) according to Claim 1 wherein the local switching controller (26A, 26B, 26N) of the semiconductor switching element (12A, 12B, 12C, 12D, 12E, 12F, 12G, 12H, 12N-1, 12N) at one end of the semiconductor switching string (10) is arranged in direct communication with the local switching controller (26A, 26B, 26N) of the semiconductor switching element (12A, 12B, 12C, 12D, 12E, 12F, 12G, 12H, 12N-1, 12N) at the other end of the semiconductor switching string (10).

4. A semiconductor switching string (10) according to Claim 1 wherein each local switching controller (26A, 26B, 26N) is configured to compare the terminal voltage of the semiconductor switching element (12A, 12B, 12C, 12D, 12E, 12F, 12G, 12H, 12N-1, 12N) with which it is operatively connected with the terminal voltage of the or each other semiconductor switching element (12A, 12B, 12C, 12D, 12E, 12F, 12G, 12H, 12N-1, 12N) from which it receives the feedback signal.

5. A semiconductor switching string (10) according to Claim 1 wherein each local switching controller (26A, 26B, 26N) includes a receiver module (44A, 44B, 44N) having a receiver unit (46) to receive the plurality of feedback signals from the other semiconductor switching elements (12A, 12B, 12C, 12D, 12E, 12F, 12G, 12H, 12N-1, 12N).

6. A semiconductor switching string (10) according to Claim 5 wherein the receiver module (44A, 44B, 44N) of each local switching controller (26A, 26B, 26N) includes an averaging unit (50) to generate a terminal voltage average value corresponding to an average of the terminal voltages of the other semiconductor switching elements (12A, 12B, 12C, 12D, 12E, 12F, 12G, 12H, 12N-1, 12N) from which the feedback signal was received.

7. A semiconductor switching string (10) according to Claim 6 wherein the receiver module (44A, 44B, 44N) of each local switching controller (26A, 26B, 26N) includes a comparator unit (54) to compare the terminal voltage average value generated by the averaging unit (50) with the terminal voltage of the semiconductor switching element (12A, 12B, 12C, 12D, 12E, 12F, 12G, 12H, 12N-1, 12N) with which the local switching controller (26A, 26B, 26N) is operatively connected and thereafter produce a terminal voltage difference value which influences the rate of change of terminal voltage of the said semiconductor switching element (12A, 12B, 12C, 12D, 12E, 12F, 12G, 12H, 12N-1, 12N) with which the local switching controller (26A, 26B, 26N) is operatively connected.

8. A semiconductor switching string (10) according to any preceding claim wherein each local switching controller (26A, 26B, 26N) includes a control module (56) to control the rate of charge applied to the third terminal (20) of the semiconductor switching element (12A, 12B, 12C, 12D, 12E, 12F, 12G, 12H, 12N-1, 12N) with which the local switching controller (26A, 26B, 26N) is operatively connected and thereby control the terminal voltage of the said semiconductor switching element (12A, 12B, 12C, 12D, 12E, 12F, 12G, 12H, 12N-1, 12N) with which the local switching controller (26A, 26B, 26N) is operatively connected.

9. A semiconductor switching string (10) according to Claim 8 wherein the control module (56) of each local switching controller (26A, 26B, 26N) is configured to vary the rate of change of terminal voltage of the semiconductor switching element (12A, 12B, 12C, 12D, 12E, 12F, 12G, 12H, 12N-1, 12N) with which the local switching controller (26A, 26B, 26N) is operatively connected at predetermined time intervals during a switching transition.

10. A semiconductor switching string (10) according to any of Claim 8 or Claim 9 wherein the control module (56) of each local switching controller (26A, 26B, 26N) is configured to:
apply a first predetermined rate of charge to the third terminal (20) of the semiconductor switching element (12A, 12B, 12C, 12D, 12E, 12F, 12G, 12H, 12N-1, 12N) with which the local switching controller (26A, 26B, 26N) is operatively connected to change the terminal voltage of the said semiconductor switching element (12A, 12B, 12C, 12D, 12E, 12F, 12G, 12H, 12N-1, 12N) with which the local switching controller (26A, 26B, 26N) is operatively connected at a first rate when the said terminal voltage is below the average of the terminal voltages of the other semiconductor switching elements (12A, 12B, 12C, 12D, 12E, 12F, 12G, 12H, 12N-1, 12N) from which the feedback signal was received, and
apply a second predetermined rate of charge to the third terminal (20) of the semiconductor switching element (12A, 12B, 12C, 12D, 12E, 12F, 12G, 12H, 12N-1, 12N) with which the local switching controller (26A, 26B, 26N) is operatively connected to change the terminal voltage of the said semiconductor switching element (12A, 12B, 12C, 12D, 12E, 12F, 12G, 12H, 12N-1, 12N) with which the local switching controller (26A, 26B, 26N) is operatively connected at a second rate different to the first rate when the said terminal voltage is above the average of the terminal voltages of the other semiconductor switching elements (12A, 12B, 12C, 12D, 12E, 12F, 12G, 12H, 12N-1, 12N) from which the feedback signal was received.

11. A semiconductor switching string (10) according to any of Claim 8 or Claim 9 wherein to switch off a given semiconductor switching element (12A, 12B, 12C, 12D, 12E, 12F, 12G, 12H, 12N-1, 12N) the control module (56) of the corresponding local switching controller (26A, 26B, 26N) is configured to:
increase the existing rate of charge applied to the third terminal (20) of the semiconductor switching element (12A, 12B, 12C, 12D, 12E, 12F, 12G, 12H, 12N-1, 12N) with which the local switching controller (26A, 26B, 26N) is operatively connected to increase the rate of change of terminal voltage of the said semiconductor switching element (12A, 12B, 12C, 12D, 12E, 12F, 12G, 12H, 12N-1, 12N) with which the local switching controller (26A, 26B, 26N) is operatively connected when the said terminal voltage is below the average of the terminal voltages of the other semiconductor switching elements (12A, 12B, 12C, 12D, 12E, 12F, 12G, 12H, 12N-1, 12N) from which the feedback signal was received, and
decrease the existing rate of charge applied to the third terminal (20) of the semiconductor switching element (12A, 12B, 12C, 12D, 12E, 12F, 12G, 12H, 12N-1, 12N) with which the local switching controller (26A, 26B, 26N) is operatively connected to decrease the rate of change of terminal voltage of the said semiconductor switching element (12A, 12B, 12C, 12D, 12E, 12F, 12G, 12H, 12N-1, 12N) with which the local switching controller (26A, 26B, 26N) is operatively connected when the said terminal voltage is above the average of the terminal voltages of the other semiconductor switching elements (12A, 12B, 12C, 12D, 12E, 12F, 12G, 12H, 12N-1, 12N) from which the feedback signal was received.

12. A semiconductor switching string (10) according to any of Claim 8, Claim 11 or 11 wherein to switch on a given semiconductor switching element (12A, 12B, 12C, 12D, 12E, 12F, 12G, 12H, 12N-1, 12N) the control module (56) of the corresponding local switching controller (26A, 26B, 26N) is configured to:
decrease the existing rate of charge applied to the third terminal (20) of the semiconductor switching element (12A, 12B, 12C, 12D, 12E, 12F, 12G, 12H, 12N-1, 12N) with which the local switching controller (26A, 26B, 26N) is operatively connected to decrease the rate of change of terminal voltage of the said semiconductor switching element (12A, 12B, 12C, 12D, 12E, 12F, 12G, 12H, 12N-1, 12N) with which the local switching controller (26A, 26B, 26N) is operatively connected when the said terminal voltage is below the average of the terminal voltages of the other semiconductor switching elements (12A, 12B, 12C, 12D, 12E, 12F, 12G, 12H, 12N-1, 12N) from which the feedback signal was received, and
increase the existing rate of charge applied to the third terminal (20) of the semiconductor switching element (12A, 12B, 12C, 12D, 12E, 12F, 12G, 12H, 12N-1, 12N) with which the local switching controller (26A, 26B, 26N) is operatively connected to increase the rate of change of terminal voltage of the said semiconductor switching element (12A, 12B, 12C, 12D, 12E, 12F, 12G, 12H, 12N-1, 12N) with which the local switching controller (26A, 26B, 26N) is operatively connected when the said terminal voltage is above the average of the terminal voltages of the other semiconductor switching elements (12A, 12B, 12C, 12D, 12E, 12F, 12G, 12H, 12N-1, 12N) from which the feedback signal was received.

13. A semiconductor switching string (10) according to any of Claims 10 to 12 wherein the control module (56) of each local switching controller (26A, 26B, 26N) is configured to vary the rate of charge applied to the third terminal (20) of the semiconductor switching element (12A, 12B, 12C, 12D, 12E, 12F, 12G, 12H, 12N-1, 12N) with which the local switching controller (26A, 26B, 26N) is operatively connected according to when during the switching transition the charge is being applied.

14. A semiconductor switching string (10) according to any preceding claim when dependent on Claim 11 wherein the control module (56) of each local switching controller (26A, 26B, 26N) is configured at each predetermined time interval of a first switching transition to apply an established rate of charge to the third terminal (20) of the semiconductor switching element (12A, 12B, 12C, 12D, 12E, 12F, 12G, 12H, 12N-1, 12N) with which the local switching controller (26A, 26B, 26N) is operatively connected, establish a revised rate of charge to be applied at the same time internal in a second subsequent corresponding switching transition, and apply the revised rate of charge at the said same time interval in the second subsequent corresponding switching transition.

15. A semiconductor switching string (10) according to any preceding claim wherein each local switching controller (26A, 26B, 26N) includes a transmitter module (62A, 62B, 62N) having a measuring unit (64) to measure the terminal voltage of the semiconductor switching element (12A, 12B, 12C, 12D, 12E, 12F, 12G, 12H, 12N-1, 12N) with which the local switching controller (62A, 62B, 62N) is operatively connected.

16. A semiconductor switching string (10) according to Claim 15 wherein the transmitter module (62A, 62B, 62N) of each local switching controller (26A, 26B, 26N) includes a transmitter unit (66) to pass the feedback signal corresponding to the measured terminal voltage of the semiconductor switching element (12A, 12B, 12C, 12D, 12E, 12F, 12G, 12H, 12N-1, 12N) with which the local switching controller (26A, 26B, 26N) is operatively connected to the local switching controller (26A, 26B, 26N) of the or each other semiconductor switching element (12A, 12B, 12C, 12D, 12E, 12F, 12G, 12H, 12N-1, 12N) arranged in direct communication with the said semiconductor switching element (12A, 12B, 12C, 12D, 12E, 12F, 12G, 12H, 12N-1, 12N) with which the local switching controller (26A, 26B, 26N) is operatively connected.

17. A semiconductor switching string (10) according to Claim 15 or 16 wherein the transmitter module (62A, 62B, 62N) of each local switching controller (26A, 26B, 26N) includes a transmitter unit (66) to pass the measured terminal voltage of the semiconductor switching element (12A, 12B, 12C, 12D, 12E, 12F, 12G, 12H, 12N-1, 12N) with which the local switching controller (26A, 26B, 26N) is operatively connected to a comparator unit (54) within the said local switching controller (26A, 26B, 26N) of which the transmitter module (62A, 62B, 62N) forms a part.

## Patentansprüche

1. Halbleiterschaltstrang (10), der mehrere in Reihe verbundene Halbleiterschaltelemente (12A, 12B, 12C, 12D, 12E, 12F, 12G, 12H, 12N-1, 12N) aufweist,
wobei jedes Halbleiterschaltelement (12A, 12B, 12C, 12D, 12E, 12F, 12G, 12H, 12N-1, 12N) enthält:
einen ersten und einen zweiten Anschluss (22, 24), zwischen denen ein Strom von dem ersten Anschluss (22) zu dem zweiten Anschluss (24) fließt, wenn das Halbleiterschaltelement (12A, 12B, 12C, 12D, 12E, 12F, 12G, 12H, 12N-1, 12N) eingeschaltet ist;
einen dritten Anschluss (20) zur Steuerung des Stroms, der von dem ersten Anschluss (22) zu dem zweiten Anschluss (24) fließt; und
eine lokale Schaltsteuerung (26A, 26B, 26N), die mit dem dritten Anschluss (20) betriebsmäßig verbunden ist, um eine Anschlussspannung zwischen dem ersten und dem zweiten Anschluss (22, 24) derart zu steuern, dass die an die Halbleiterschaltelemente innerhalb des Schaltstranges angelegten Spannungen aufeinander abgestimmt sind,
wobei der Halbleiterschaltstrang **dadurch gekennzeichnet ist, dass**
jede lokale Schaltsteuerung (26A, 26B, 26N) jedes Halbleiterschaltelementes (12A, 12B, 12C, 12D, 12E, 12F, 12G, 12H, 12N-1, 12N) mit wenigstens jedem von ihren nächsten Nachbarin in dem Halbleiterschaltstrang in direkter Kommunikationsverbindung angeordnet ist und außerdem mit den lokalen Schaltsteuerungen (26A, 26B, 26N) von mehreren weiteren Halbleiterschaltelementen (12A, 12B, 12C, 12D, 12E, 12F, 12G, 12H, 12N-1, 12N) über die oder jede lokale Schaltsteuerung (26A, 26B, 26N) des oder jedes Halbleiterschaltelementes (12A, 12B, 12C, 12D, 12E, 12F, 12G, 12H, 12N-1, 12N), mit dem sie in direkter Kommunikationsverbindung angeordnet ist, in indirekter Kommunikationsverbindung angeordnet ist,
wobei die lokale Schaltsteuerung eines jeweiligen Halbleiterschaltelementes, die in direkter Kommunikationsverbindung mit einem oder mehreren anderen lokalen Schaltsteuerungen angeordnet ist, eingerichtet ist, um unmittelbar von der oder jeder anderen lokalen Schaltsteuerung ein Rückmeldesignal zu empfangen, das der Anschlussspannung des Halbleiterschaltelementes der oder jeder anderen lokalen Schaltsteuerung entspricht,
wobei jede lokale Schaltsteuerung (26A, 26B, 26N) eingerichtet ist, um während eines Schaltübergangs die Änderungsrate der Anschlussspannung des Halbleiterschaltelementes (12A, 12B, 12C, 12D, 12E, 12F, 12G, 12H, 12N-1, 12N), mit dem sie betriebsmäßig verbunden ist, derart zu variieren, dass
das Maß, in dem jede lokale Schaltsteuerung (26A, 26B, 26N) die Änderungsrate der Anschlussspannung des Halbleiterschaltelementes (12A, 12B, 12C, 12D, 12E, 12F, 12G, 12H, 12N-1, 12N), mit dem sie betriebsmäßig verbunden ist, variiert, in einem primären Maße durch das oder jedes Rückmeldesignal, das der Anschlussspannung des oder jedes Halbleiterschaltelementes (12A, 12B, 12C, 12D, 12E, 12F, 12G, 12H, 12N-1, 12N) entspricht, mit dem ihr zugeordnetes Halbleiterschaltelement (12A, 12B, 12C, 12D, 12E, 12F, 12G, 12H, 12N-1, 12N) in direkter Kommunikationsverbindung angeordnet ist, und in einem sekundären Maße durch die Anschlussspannung jedes weiteren Halbleiterschaltelementes (12A, 12B, 12C, 12D, 12E, 12F, 12G, 12H, 12N-1, 12N) beeinflusst wird, mit dem ihr zugeordnetes Halbleiterschaltelement (12A, 12B, 12C, 12D, 12E, 12F, 12G, 12H, 12N-1, 12N) in indirekter Kommunikationsverbindung angeordnet ist.

2. Halbleiterschaltstrang (10) nach Anspruch 1, wobei jede lokale Schaltsteuerung (26A, 26B, 26N) jedes Halbleiterschaltelementes (12A, 12B, 12C, 12D, 12E, 12F, 12G, 12H, 12N-1, 12N) entweder in direkter oder in indirekter Kommunikationsverbindung mit jeder anderen lokalen Schaltsteuerung (26A, 26B, 26N) jedes anderen Halbleiterschaltelementes (12A, 12B, 12C, 12D, 12E, 12F, 12G, 12H, 12N-1, 12N) in dem Halbleiterschaltstrang (10) angeordnet ist.

3. Halbleiterschaltstrang (10) nach Anspruch 1, wobei die lokale Schaltsteuerung (26A, 26B, 26N) des Halbleiterschaltelementes (12A, 12B, 12N) an einem Ende des Halbleiterschaltstrangs (10) mit der lokalen Schaltsteuerung (26A, 26B, 26N) des Halbleiterschaltelementes (12A, 12B, 12N) an dem anderen Ende des Halbleiterschaltstranges (10) in direkter Kommunikationsverbindung angeordnet ist.

4. Halbleiterschaltstrang (10) nach Anspruch 1, wobei jede lokale Schaltsteuerung (26A, 26B, 26N) eingerichtet ist, um die Anschlussspannung des Halbleiterschaltelementes (12A, 12B, 12C, 12D, 12E, 12F, 12G, 12H, 12N-1, 12N), mit dem sie betriebsmäßig verbunden ist, mit der Anschlussspannung des oder jedes anderen Halbleiterschaltelementes (12A, 12B, 12C, 12D, 12E, 12F, 12G, 12H, 12N-1, 12N) zu vergleichen, von dem sie das Rückmeldesignal empfängt.

5. Halbleiterschaltstrang (10) nach Anspruch 1, wobei jede lokale Schaltsteuerung (26A, 26B, 26N) ein Empfängermodul (44A, 44B, 44N) mit einer Empfängereinheit (46) enthält, um die mehreren Rückmeldesignale von den anderen Halbleiterschaltelementen (12A, 12B, 12C, 12D, 12E, 12F, 12G, 12H, 12N-1, 12N) zu empfangen.

6. Halbleiterschaltstrang (10) nach Anspruch 5, wobei das Empfängermodul (44A, 44B, 44N) jeder lokalen Schaltsteuerung (26A, 26B, 26N) eine Mittelwertbildungseinheit (50) enthält, um einen Anschlussspannungsmittelwert zu bilden, der einem Mittelwert der Anschlussspannungen der anderen Halbleiterschaltelemente (12A, 12B, 12C, 12D, 12E, 12F, 12G, 12H, 12N-1, 12N), von denen das Rückmeldesignal empfangen wurde, entspricht.

7. Halbleiterschaltstrang (10) nach Anspruch 6, wobei das Empfängermodul (44A, 44B, 44N) jeder lokalen Schaltsteuerung (26A, 26B, 26N) eine Vergleichereinheit (54) enthält, um den durch die Mittelwertbildungseinheit (50) gebildeten Anschlussspannungsmittelwert mit der Anschlussspannung des Halbleiterschaltelementes (12A, 12B, 12C, 12D, 12E, 12F, 12G, 12H, 12N-1, 12N) zu vergleichen, mit dem die lokale Schaltsteuerung (26A, 26B, 26N) betriebsmäßig verbunden ist, und danach einen Anschlussspannungsdifferenzwert zu erzeugen, der die Änderungsrate der Anschlussspannung des Halbleiterschaltelementes (12A, 12B, 12C, 12D, 12E, 12F, 12G, 12H, 12N-1, 12N) beeinflusst, mit dem die lokale Schaltsteuerung (26A, 26B, 26N) betriebsmäßig verbunden ist.

8. Halbleiterschaltstrang (10) nach einem beliebigen vorhergehenden Anspruch, wobei jede lokale Schaltsteuerung (26A, 26B, 26N) ein Steuermodul (56) enthält, um den Ladestrom zu steuern, der an den dritten Anschluss (20) des Halbleiterschaltelementes (12A, 12B, 12C, 12D, 12E, 12F, 12G, 12H, 12N-1, 12N) angelegt wird, mit dem die lokale Schaltsteuerung (26A, 26B, 26N) betriebsmäßig verbunden ist, und dadurch die Anschlussspannung des Halbleiterschaltelementes (12A, 12B, 12C, 12D, 12E, 12F, 12G, 12H, 12N-1, 12N) zu steuern, mit dem die lokale Schaltsteuerung (26A, 26B, 26N) betriebsmäßig verbunden ist.

9. Halbleiterschaltstrang (10) nach Anspruch 8, wobei das Steuermodul (56) jeder lokalen Schaltsteuerung (26A, 26B, 26N) eingerichtet ist, um die Änderungsrate der Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, während eines Schaltüberganges in vorbestimmten Zeitintervallen zu variieren.

10. Halbleiterschaltstrang (10) nach einem beliebigen von dem Anspruch 8 oder Anspruch 9, wobei das Steuermodul (56) jeder lokalen Schaltsteuerung (26A, 26B, 26N) eingerichtet ist, um:
einen ersten vorbestimmten Ladestrom an den dritten Anschluss (20) des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, anzulegen, um die Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, mit einer ersten Rate zu verändern, wenn die Anschlussspannung unterhalb des Mittelwertes der Anschlussspannungen der anderen Halbleiterschaltelemente (12A, 12B, 12C, 12D, 12E, 12F, 12G, 12H, 12N-1, 12N), von denen das Rückmeldesignal empfangen wurde, liegt, und
einen zweiten vorbestimmten Ladestrom an den dritten Anschluss (20) des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, anzulegen, um die Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, mit einer zweiten Rate, die sich von der ersten Rate unterscheidet, zu verändern, wenn die Anschlussspannung oberhalb des Mittelwertes der Anschlussspannungen der anderen Halbleiterschaltelemente (12A, 12B, 12C, 12D, 12E, 12F, 12G, 12H, 12N-1, 12N), von denen das Rückmeldesignal empfangen wurde, liegt.

11. Halbleiterschaltstrang (10) nach einem beliebigen von dem Anspruch 8 oder Anspruch 9, wobei zum Abschalten eines gegebenen Halbleiterschaltelementes (12A, 12B, 12C, 12D, 12E, 12F, 12G, 12H, 12N-1, 12N) das Steuermodul (56) der zugehörigen lokalen Schaltsteuerung (26A, 26B, 26N) eingerichtet ist, um:
den vorliegenden Ladestrom, der an den dritten Anschluss (20) des Halbleiterschaltelementes (12A, 12B, 12C, 12D, 12E, 12F, 12G, 12H, 12N-1, 12N) angelegt wird, mit dem die lokale Schaltsteuerung (26A, 26B, 26N) betriebsmäßig verbunden ist, zu erhöhen, um die Änderungsrate der Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, zu erhöhen, wenn die Anschlussspannung unterhalb des Mittelwertes der Anschlussspannungen der anderen Halbleiterschaltelemente (12A, 12B, 12C, 12D, 12E, 12F, 12G, 12H, 12N-1, 12N), von denen das Rückmeldesignal empfangen wurde, liegt, und
den vorliegenden Ladestrom, der an den dritten Anschluss (20) des Halbleiterschaltelementes (12A, 12B, 12C, 12D, 12E, 12F, 12G, 12H, 12N-1, 12N) angelegt wird, mit dem die lokale Schaltsteuerung (26A, 26B, 26N) betriebsmäßig verbunden ist, zu verringern, um die Änderungsrate der Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26n) betriebsmäßig verbunden ist, zu verringern, wenn die Anschlussspannung oberhalb des Mittelwertes der Anschlussspannungen der anderen Halbleiterschaltelemente (12A, 12B, 12C, 12D, 12E, 12F, 12G, 12H, 12N-1, 12N), von denen das Rückmeldesignal empfangen wurde, liegt.

12. Halbleiterschaltstrang (10) nach einem beliebigen von dem Anspruch 8, Anspruch 11 oder 11, wobei zum Einschalten eines gegebenen Halbleiterschaltelementes (12A, 12B, 12C, 12D, 12E, 12F, 12G, 12H, 12N-1, 12N) das Steuermodul (56) der zugehörigen lokalen Schaltsteuerung (26A, 26B, 26N) eingerichtet ist, um:
den vorliegenden Ladestrom, der an den dritten Anschluss (20) des Halbleiterschaltelementes (12A, 12B, 12C, 12D, 12E, 12F, 12G, 12H, 12N-1, 12N) angelegt wird, mit dem die lokale Schaltsteuerung (26A, 26B, 26N) betriebsmäßig verbunden ist, zu verringern, um die Änderungsrate der Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, zu verringern, wenn die Anschlussspannung unterhalb des Mittelwertes der Anschlussspannungen der anderen Halbleiterschaltelemente (12A, 12B, 12C, 12D, 12E, 12F, 12G, 12H, 12N-1, 12N), von denen das Rückmeldesignal empfangen wurde, liegt, und
den vorliegenden Ladestrom, der an den dritten Anschluss (20) des Halbleiterschaltelementes (12A, 12B, 12C, 12D, 12E, 12F, 12G, 12H, 12N-1, 12N) angelegt wird, mit dem die lokale Schaltsteuerung (26A, 26B, 26N) betriebsmäßig verbunden ist, zu erhöhen, um die Änderungsrate der Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, zu erhöhen, wenn die Anschlussspannung oberhalb des Mittelwertes der Anschlussspannungen der anderen Halbleiterschaltelemente (12A, 12B, 12C, 12D, 12E, 12F, 12G, 12H, 12N-1, 12N), von denen das Rückmeldesignal empfangen wurde, liegt.

13. Halbleiterschaltstrang (10) nach einem beliebigen der Ansprüche 10 bis 12, wobei das Steuermodul (56) jeder lokalen Schaltsteuerung (26A, 26B, 26N) eingerichtet ist, um den Ladestrom, der an den dritten Anschluss (20) des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, angelegt wird, danach zu variieren, wann während des Schaltüberganges die Ladung angelegt wird.

14. Halbleiterschaltstrang (10) nach einem beliebigen vorhergehenden Anspruch, wenn dieser vom Anspruch 11 abhängig ist, wobei das Steuermodul (56) jeder lokalen Schaltsteuerung (26A, 26B, 26N) in jedem vorbestimmten Zeitintervall eines ersten Schaltübergangs eingerichtet ist, um einen festgelegten Ladestrom an den dritten Anschluss (20) des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, anzulegen, einen revidierten Ladestrom festzulegen, die in demselben Zeitintervall in einem zweiten nachfolgenden entsprechenden Schaltübergang angelegt werden soll, und den revidierten Ladestrom in demselben Zeitintervall in dem zweiten nachfolgenden entsprechenden Schaltübergang anzulegen.

15. Halbleiterschaltstrang (10) nach einem beliebigen vorhergehenden Anspruch, wobei jede lokale Schaltsteuerung (26A, 26B, 26N) ein Sendermodul (62A, 62B, 62N) mit einer Messeinheit (64) enthält, um die Anschlussspannung des Halbleiterschaltelementes (12A, 12B, 12C, 12D, 12E, 12F, 12G, 12H, 12N-1, 12N), mit dem die lokale Schaltsteuerung (62A, 62B, 62N) betriebsmäßig verbunden ist, zu messen.

16. Halbleiterschaltstrang (10) nach Anspruch 15, wobei das Sendermodul (62A, 62B, 62N) jeder lokalen Schaltsteuerung (26A, 26B, 26N) eine Sendereinheit (66) enthält, um das Rückmeldesignal, das der gemessenen Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, entspricht, zu der lokalen Schaltsteuerung (26A, 26B, 26N) des oder jedes anderen Halbleiterschaltelementes (12A, 12B, 12C, 12D, 12E, 12F, 12G, 12H, 12N-1, 12N) weiterzuleiten, das mit dem Halbleiterschaltelement (12A, 12B, 12C, 12D, 12E, 12F, 12G, 12H, 12N-1, 12N), mit dem die lokale Schaltsteuerung (26A, 26B, 26N) betriebsmäßig verbunden ist, in direkter Kommunikationsverbindung angeordnet ist.

17. Halbleiterschaltstrang (10) nach Anspruch 15 oder 16, wobei das Sendermodul (62A, 62B, 62N) jeder lokalen Schaltsteuerung (26A, 26B, 26N) eine Sendereinheit (66) enthält, um die gemessene Anschlussspannung des Halbleiterschaltelementes (12A, 12B, 12C, 12D, 12E, 12F, 12G, 12H, 12N-1, 12N), mit dem die lokale Schaltsteuerung (26A, 26B, 26N) betriebsmäßig verbunden ist, zu einer Vergleichereinheit (54) innerhalb der lokalen Schaltsteuerung (26A, 26B, 26N), von der das Sendermodul (62A, 62B, 62N) einen Teil bildet, weiterzuleiten.

## Revendications

1. Chaîne de commutation à semi-conducteur (10) comprenant une pluralité d'éléments de commutation à semi-conducteur montés en série (12A, 12B, 12C, 12D, 12E, 12F, 12G, 12H, 12N-1, 12N),
chaque élément de commutation à semi-conducteur (12A, 12B, 12C, 12D, 12E, 12F, 12G, 12H, 12N-1, 12N) comportant :
une première et une deuxième borne (22, 24) entre lesquelles un courant circule de la première borne (22) vers la deuxième borne (24) quand l'élément de commutation à semi-conducteur (12A, 12B, 12C, 12D, 12E, 12F, 12G, 12H, 12N-1, 12N) est rendu passant ;
une troisième borne (20) pour commander ledit courant circulant de la première borne (22) vers la deuxième borne (24) ; et
un contrôleur de commutation local (26A, 26B, 26N) relié fonctionnellement à la troisième borne (20) pour régler une tension de borne entre les première et deuxième bornes (22, 24), de sorte que les tensions appliquées aux éléments de commutation à semi-conducteur dans la chaîne de commutation sont coordonnées, la chaîne de commutation à semi-conducteur étant **caractérisée en ce que**
chaque contrôleur de commutation local (26A, 26B, 26N) de chaque élément de commutation à semi-conducteur (12A, 12B, 12C, 12D, 12E, 12F, 12G, 12H, 12N-1, 12N) étant placé en communication directe avec au moins chacun de ses voisins les plus proches dans la chaîne de commutation à semi-conducteur et étant en outre placé en communication indirecte avec les contrôleurs de commutation locaux (26A, 26B, 26N) d'une pluralité d'éléments de commutation à semi-conducteur supplémentaires (12A, 12B, 12C, 12D, 12E, 12F, 12G, 12H, 12N-1, 12N) via le ou chaque contrôleur de commutation local (26A, 26B, 26N) du ou de chaque élément de commutation à semi-conducteur (12A, 12B, 12C, 12D, 12E, 12F, 12G, 12H, 12N-1, 12N) avec lequel il est placé en communication directe,
dans laquelle le contrôleur de commutation local d'un élément de commutation à semi-conducteur respectif placé en communication directe avec un ou plusieurs autres contrôleurs de commutation locaux est configuré pour recevoir directement du ou de chaque contrôleur de commutation local un signal de rétroaction correspondant à la tension de borne de l'élément de commutation à semi-conducteur du ou de chaque contrôleur de commutation local,
chaque contrôleur de commutation local (26A, 26B, 26N) étant configuré pour faire varier pendant une transition de commutation le taux de variation de la tension de borne de l'élément de commutation à semi-conducteur (12A, 12B, 12C, 12D, 12E, 12F, 12G, 12H, 12N-1, 12N) avec lequel il est relié fonctionnellement, de sorte que
le degré avec lequel chaque contrôleur de commutation local (26A, 26B, 26N) fait varier ledit taux de variation de la tension de borne de l'élément de commutation à semi-conducteur (12A, 12B, 12C, 12D, 12E, 12F, 12G, 12H, 12N-1, 12N) avec lequel il est relié fonctionnellement est influencé de façon principale par le ou chaque signal de rétroaction correspondant à la tension de borne du ou de chaque élément de commutation à semi-conducteur (12A, 12B, 12C, 12D, 12E, 12F, 12G, 12H, 12N-1, 12N) avec lequel son élément de commutation à semi-conducteur associé (12A, 12B, 12C, 12D, 12E, 12F, 12G, 12H, 12N-1, 12N) est placé en communication directe, et de façon secondaire par la tension de borne de chaque élément de commutation à semi-conducteur supplémentaire (12A, 12B, 12C, 12D, 12E, 12F, 12G, 12H, 12N-1, 12N) avec lequel son élément de commutation à semi-conducteur associé (12A, 12B, 12C, 12D, 12E, 12F, 12G, 12H, 12N-1, 12N) est placé en communication indirecte.

2. Chaîne de commutation à semi-conducteur (10) selon la revendication 1, dans laquelle chaque contrôleur de commutation local (26A, 26B, 26N) de chaque élément de commutation à semi-conducteur (12A, 12B, 12C, 12D, 12E, 12F, 12G, 12H, 12N-1, 12N) est placé soit en communication directe, soit en communication indirecte avec chaque autre contrôleur de commutation local (26A, 26B, 26N) de chaque autre élément de commutation à semi-conducteur (12A, 12B, 12C, 12D, 12E, 12F, 12G, 12H, 12N-1, 12N) dans la chaîne de commutation à semi-conducteur (10).

3. Chaîne de commutation à semi-conducteur (10) selon la revendication 1, dans laquelle le contrôleur de commutation local (26A, 26B, 26N) de l'élément de commutation à semi-conducteur (12A, 12B, 12C, 12D, 12E, 12F, 12G, 12H, 12N-1, 12N) à une extrémité de la chaîne de commutation à semi-conducteur (10) est placé en communication directe avec le contrôleur de commutation local (26A, 26B, 26N) de l'élément de commutation à semi-conducteur (12A, 12B, 12C, 12D, 12E, 12F, 12G, 12H, 12N-1, 12N) à l'autre extrémité de la chaîne de commutation à semi-conducteur (10).

4. Chaîne de commutation à semi-conducteur (10) selon la revendication 1, dans laquelle chaque contrôleur de commutation local (26A, 26B, 26N) est configuré pour comparer la tension de borne de l'élément de commutation à semi-conducteur (12A, 12B, 12C, 12D, 12E, 12F, 12G, 12H, 12N-1, 12N) avec lequel il est relié fonctionnellement avec la tension de borne du ou de chaque autre élément de commutation à semi-conducteur (12A, 12B, 12C, 12D, 12E, 12F, 12G, 12H, 12N-1, 12N) duquel il reçoit le signal de rétroaction.

5. Chaîne de commutation à semi-conducteur (10) selon la revendication 1, dans laquelle chaque contrôleur de commutation local (26A, 26B, 26N) comporte un module récepteur (44A, 44B, 44N) ayant une unité de récepteur (46) pour recevoir la pluralité de signaux de rétroaction provenant des autres éléments de commutation à semi-conducteur (12A, 12B, 12C, 12D, 12E, 12F, 12G, 12H, 12N-1, 12N).

6. Chaîne de commutation à semi-conducteur (10) selon la revendication 5, dans laquelle le module récepteur (44A, 44B, 44N) de chaque contrôleur de commutation local (26A, 26B, 26N) comporte une unité de calcul de moyenne (50) pour générer une valeur de moyenne de tension de borne correspondant à une moyenne des tensions de borne des autres éléments de commutation à semi-conducteur (12A, 12B, 12C, 12D, 12E, 12F, 12G, 12H, 12N-1, 12N) d'où est venu le signal de rétroaction.

7. Chaîne de commutation à semi-conducteur (10) selon la revendication 6, dans laquelle le module récepteur (44A, 44B, 44N) de chaque contrôleur de commutation local (26A, 26B, 26N) comporte une unité de comparaison (54) pour comparer la valeur de moyenne de tension de borne générée par l'unité de calcul de moyenne (50) avec la tension de borne de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement.

8. Chaîne de commutation à semi-conducteur (10) selon l'une quelconque des revendications précédentes, dans laquelle chaque contrôleur de commutation local (26A, 26B, 26N) comporte un module de commande (56) pour commander le taux de charge appliqué à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement et pour commander de ce fait la tension de borne dudit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement.

9. Chaîne de commutation à semi-conducteur (10) selon la revendication 8, dans laquelle le module de commande (56) de chaque contrôleur de commutation local (26A, 26B, 26N) est configuré pour faire varier le taux de variation de la tension de borne de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement à des intervalles de temps prédéterminés pendant une transition de commutation.

10. Chaîne de commutation à semi-conducteur (10) selon l'une quelconque des revendications 8 et 9, dans laquelle le module de commande (56) de chaque contrôleur de commutation local (26A, 26B, 26N) est configuré pour :
appliquer un premier taux de charge prédéterminé à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement pour modifier la tension de borne dudit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement avec un premier taux quand ladite tension de borne est inférieure à la moyenne des tensions de borne des autres éléments de commutation à semi-conducteur (12A, 12B, 12C, 12D, 12E, 12F, 12G, 12H, 12N-1, 12N) d'où est venu le signal de rétroaction, et
appliquer un deuxième taux de charge prédéterminé à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement pour modifier la tension de borne dudit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement avec un deuxième taux, différent du premier taux, quand ladite tension de borne est supérieure à la moyenne des tensions de borne des autres éléments de commutation à semi-conducteur (12A, 12B, 12C, 12D, 12E, 12F, 12G, 12H, 12N-1, 12N) d'où est venu le signal de rétroaction.

11. Chaîne de commutation à semi-conducteur (10) selon l'une quelconque des revendications 8 et 9, dans laquelle, pour bloquer un élément de commutation à semi-conducteur donné (12A, 12B, 12C, 12D, 12E, 12F, 12G, 12H, 12N-1, 12N), le module de commande (56) du contrôleur de commutation local correspondant (26A, 26B, 26N) est configuré pour :
augmenter le taux de charge existant appliqué à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement pour augmenter le taux de variation de la tension de borne dudit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement quand ladite tension de borne est inférieure à la moyenne des tensions de borne des autres éléments de commutation à semi-conducteur (12A, 12B, 12C, 12D, 12E, 12F, 12G, 12H, 12N-1, 12N) d'où est venu le signal de rétroaction, et
réduire le taux de charge existant appliqué à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement pour réduire le taux de variation de la tension de borne dudit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement quand ladite tension de borne est supérieure à la moyenne des tensions de borne des autres éléments de commutation à semi-conducteur (12A, 12B, 12C, 12D, 12E, 12F, 12G, 12H, 12N-1, 12N) d'où est venu le signal de rétroaction.

12. Chaîne de commutation à semi-conducteur (10) selon l'une quelconque des revendications 8, 11 et 11, dans laquelle, pour rendre passant un élément de commutation à semi-conducteur donné (12A, 12B, 12C, 12D, 12E, 12F, 12G, 12H, 12N-1, 12N), le module de commande (56) du contrôleur de commutation local correspondant (26A, 26B, 26N) est configuré pour :
réduire le taux de charge existant appliqué à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement pour réduire le taux de variation de la tension de borne dudit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement quand ladite tension de borne est inférieure à la moyenne des tensions de borne des autres éléments de commutation à semi-conducteur (12A, 12B, 12C, 12D, 12E, 12F, 12G, 12H, 12N-1, 12N) d'où est venu le signal de rétroaction, et
augmenter le taux de charge existant appliqué à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement pour augmenter le taux de variation de la tension de borne dudit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement quand ladite tension de borne est supérieure à la moyenne des tensions de borne des autres éléments de commutation à semi-conducteur (12A, 12B, 12C, 12D, 12E, 12F, 12G, 12H, 12N-1, 12N) d'où est venu le signal de rétroaction.

13. Chaîne de commutation à semi-conducteur (10) selon l'une quelconque des revendications 10 à 12, dans laquelle le module de commande (56) de chaque contrôleur de commutation local (26A, 26B, 26N) est configuré pour faire varier le taux de charge appliqué à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement selon le moment auquel la charge est appliquée pendant la transition de commutation.

14. Chaîne de commutation à semi-conducteur (10) selon l'une quelconque des revendications précédentes lorsqu'elles dépendent de la revendication 11, dans laquelle le module de commande (56) de chaque contrôleur de commutation local (26A, 26B, 26N) est configuré à chaque intervalle de temps prédéterminé d'une première transition de commutation pour appliquer un taux de charge établi à la troisième borne (20) de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement, établir un taux de charge révisé destiné à être appliqué au même intervalle de temps dans une deuxième transition de commutation correspondante consécutive, et appliquer le taux de charge révisé audit même intervalle de temps dans la deuxième transition de commutation correspondante consécutive.

15. Chaîne de commutation à semi-conducteur (10) selon l'une quelconque des revendications précédentes, dans laquelle chaque contrôleur de commutation local (26A, 26B, 26N) comporte un module émetteur (62A, 62B, 62N) ayant une unité de mesure (64) pour mesurer la tension de borne de l'élément de commutation à semi-conducteur (12A, 12B, 12C, 12D, 12E, 12F, 12G, 12H, 12N-1, 12N) avec lequel le contrôleur de commutation local (62A, 62B, 62N) est relié fonctionnellement.

16. Chaîne de commutation à semi-conducteur (10) selon la revendication 15, dans laquelle le module émetteur (62A, 62B, 62N) de chaque contrôleur de commutation local (26A, 26B, 26N) comporte une unité d'émetteur (66) pour transmettre le signal de rétroaction correspondant à la tension de borne mesurée de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement au contrôleur de commutation local (26A, 26B, 26N) du ou de chaque autre élément de commutation à semi-conducteur (12A, 12B, 12C, 12D, 12E, 12F, 12G, 12H, 12N-1, 12N) placé en communication directe avec ledit élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement.

17. Chaîne de commutation à semi-conducteur (10) selon la revendication 15 ou 16, dans laquelle le module émetteur (62A, 62B, 62N) de chaque contrôleur de commutation local (26A, 26B, 26N) comporte une unité d'émetteur (66) pour transmettre la tension de borne mesurée de l'élément de commutation à semi-conducteur (12A, 12B, 12C, 12D, 12E, 12F, 12G, 12H, 12N-1, 12N) avec lequel le contrôleur de commutation local (26A, 26B, 26N) est relié fonctionnellement à une unité de comparaison (54) située dans ledit contrôleur de commutation local (26A, 26B, 26N) dont le module émetteur (62A, 62B, 62N) fait partie.
